(19) Europäisches Patentamt / European Patent Office / Office européen des brevets

(11) **EP 2 304 828 B1**

(12) **EUROPÄISCHE PATENTSCHRIFT**

(45) Veröffentlichungstag und Bekanntmachung des Hinweises auf die Patenterteilung:
**31.10.2018   Patentblatt 2018/44**

(51) Int Cl.:
*H01M 4/62* *(2006.01)*      *C01G 45/12* *(2006.01)*
*H01M 4/505* *(2010.01)*     *H01M 4/131* *(2010.01)*
*H01M 10/052* *(2010.01)*    *C01B 35/12* *(2006.01)*

(21) Anmeldenummer: **09768968.1**

(22) Anmeldetag: **23.06.2009**

(86) Internationale Anmeldenummer:
**PCT/EP2009/004512**

(87) Internationale Veröffentlichungsnummer:
**WO 2009/156119 (30.12.2009 Gazette 2009/53)**

(54) **MISCHOXID ENTHALTEND EINEN LITHIUM-MANGAN-SPINELL UND VERFAHREN ZU DESSEN HERSTELLUNG**

MIXED OXIDE CONTAINING A LITHIUM-MANGANESE SPINEL AND PROCESS FOR PRODUCING IT

MÉLANGE D'OXYDES CONTENANT UN SPINELLE LITHIUM-MANGANÈSE ET SON PROCÉDÉ DE FABRICATION

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **24.06.2008   DE 102008029804**

(43) Veröffentlichungstag der Anmeldung:
**06.04.2011   Patentblatt 2011/14**

(73) Patentinhaber: **Johnson Matthey PLC London EC4A 4AB (GB)**

(72) Erfinder:
• **VOGLER, Christian**
  **85368 Moosburg (DE)**
• **NUSPL, Gerhard**
  **81543 München (DE)**
• **WOHLFAHRT-MEHRENS, Margret**
  **89257 Illertissen (DE)**
• **AXMANN, Peter**
  **89155 Erbach (DE)**
• **ARNOLD, Gisela**
  **89077 Ulm (DE)**

(74) Vertreter: **Gee, Rachel Sarah Johnson Matthey Technology Centre Blount's Court Sonning Common Reading, Berkshire RG4 9NH (GB)**

(56) Entgegenhaltungen:
EP-A1- 2 214 232      EP-A1- 2 214 233
DE-A1- 19 935 090     JP-A- 8 195 200
JP-A- 2001 048 547    JP-A- 2002 170 566
JP-A- 2005 112 710    US-A1- 2003 054 248
US-A1- 2008 032 198   US-B2- 7 217 406
US-B2- 7 294 435

• HIBINO M ET AL: "Improvement of cycle life of spinel type of lithium manganese oxide by addition of other spinel compounds during synthesis", SOLID STATE IONICS, NORTH HOLLAND PUB. COMPANY. AMSTERDAM; NL, NL, vol. 177, no. 26-32, 31 October 2006 (2006-10-31), pages 2653-2656, XP025033535, ISSN: 0167-2738, DOI: DOI:10.1016/J.SSI.2006.03.024 [retrieved on 2006-10-31]

Bemerkungen:
Die Akte enthält technische Angaben, die nach dem Eingang der Anmeldung eingereicht wurden und die nicht in dieser Patentschrift enthalten sind.

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Mischoxid enthaltend einen gemischt dotierten Lithium-Mangan-Spinell und eine Bor-Sauerstoff-Verbindung sowie ein Verfahren zur Herstellung sowie dessen Verwendung, insbesondere als Kathodenmaterial in Lithiumionen-Sekundärbatterien.

Wiederaufladbare Lithiumionen-Batterien zeichnen sich durch hohe spezifische Energie und Leistung aus. Sie werden daher bevorzugt in Anwendungen eingesetzt, die ein möglichst geringes Gewicht und einen geringen Platzbedarf erfordern. So werden für tragbare elektronische Geräte, wie z. B. Videokameras, Laptop-Computer oder Mobiltelefone heute überwiegend Lithiumionen-Sekundärbatterien als Energiespeicher verwendet. Werden die Herstellungskosten von wiederaufladbaren Lithium-Batterien weiter gesenkt, sind weitere potentielle Anwendungen denkbar, wie z.B. kabellose Elektrowerkzeuge (power tools), Bordnetz-, Traktions- oder Hybridbatterien in Fahrzeugen, oder auch in stationären Anwendungen, z.B. für Notstromversorgungseinrichtungen.

Das Funktionsprinzip heutiger Lithiumionen-Batterien beruht auf der Verwendung von Elektrodenmaterialien, die Lithium reversibel interkalieren können. Derzeit werden üblicherweise Kohlenstoffverbindungen als Anode und ein lithiumhaltiges Oxid als Kathode verwendet.

Um möglichst hohe Energiedichten erhalten zu können, werden vorzugsweise Kathodenmaterialien verwendet, die Lithium bei Potentialen zwischen 3 und 4 V vs. Li/Li+ interkalieren können. Zu den aussichtsreichsten Materialien, die diesen Anforderungen genügen, gehören Lithiumverbindungen auf Basis von Kobalt-, Nickel-, Eisen- und Manganoxiden. Aus Kostengründen und wegen der höheren Umweltfreundlichkeit und Anwendungssicherheit werden derzeit mangan- und eisenbasierte Materialien bevorzugt.

Unter den Lithium-Mangan-Oxiden zeigen Verbindungen mit Spinellstruktur wie z. B. $LiMn_2O_4$ (stöchiometrischer Spinell), $Li_2Mn_4O_9$ (sauerstoffreicher Spinell) und $Li_4Mn_5O_{12}$ (lithiumreicher Spinell) die vielversprechendsten Eigenschaften als Kathodenmaterialien. In der Regel werden diese Spinelle mittels Festkörperreaktionen hergestellt. Dabei entstehen in der Regel stöchiometrische Spinelle, die jedoch meist nur eine unzureichende Zyklenlebensdauer aufweisen. Dies wird auf Änderungen und Defekte in der Gitterstruktur zurückgeführt, die beim Ein- und Ausbau von Lithiumionen auftreten.

In US 4,507,371 wird eine elektrochemische Zelle beschrieben, bei der Anode, Elektrolyt oder Kathode jeweils ein Material aufweisen, das eine kubisch dichtgepackte Rahmenstruktur hat, die als Grundstruktureinheit eine Einheit der Formel $(B_2)X_4^{n-}$ besitzt und die Struktureinheit eines $A(B_2)X_4$-Spinells ist. Die Struktur nimmt aktive Kationen $M^+$ auf, die innerhalb dieser Struktur diffundieren können. Diese Schrift beschreibt darüber hinaus die in der Strukturchemie für Spinellstrukturen vom Typ $AB_2X_4$ bekannten Formen von Kristalldefekten und Stöchiometrieabweichungen, wie etwa den teilweisen Ersatz von B-Kationen durch A-Kationen oder den Mangel oder Überschuss von X-Anionen und lehrt, dass diese einen nicht genauer quantifizierten Einfluss auf die elektrochemischen Eigenschaften nehmen können.

Die US 5,316,877 beschreibt Spinellverbindungen der allgemeinen Formel $Li_1D_{x/b}Mn_{2-x}O_{4+\delta}$ mit $0 \leq x < 0,33$; $0 \leq \delta < 0,5$; wobei D vorzugsweise Li, Mg, Co, und b die Oxidationsstufe dieses Kations ist. Die beschriebenen Ausführungsbeispiele beschränken sich auf den Fall D=Li. Die Herstellung erfolgt nach einem Festkörperverfahren, bei dem $LiNO_3$, oder LiOH mit $\gamma$-$MnO_2$ im gewünschten Molverhältnis zusammen mit Hexan in einer Kugelmühle vermengt werden. Anschließend wird die Mischung für 48 h an Luft bei 450°C kalziniert und für weitere 48 h bei 750°C kalziniert.

In der EP 0 783 459 B1 werden dotierte Lithiumkomplexoxide der allgemeinen Formel $Li_yMe_xMn_{2-x}O_4$ beschrieben, welche eine Kristallstruktur vom Spinelltyp aufweisen und sich als Kathodenmaterial in Lithium-Sekundärbatterien eignen. Die mit diesen Kathoden hergestellten Batterien sollen eine gute Zyklenlebensdauer zeigen. Der Lithium-Mangan-Spinell wird hergestellt, indem der Stöchiometrie des herzustellenden Spinells entsprechende Mengen der Reaktionskomponenten in Form von Hydroxiden und/oder wasserlöslichen Metallsalzen in gelöster Form in einem basischen wässrigen Medium unter Bildung einer homogenen Suspension umgesetzt werden. Die getrockneten Reaktionsprodukte werden anschließend mit einer Aufheizgeschwindigkeit von 1 - 20 K/min auf Temperaturen zwischen 500 und 900°C erhitzt, wobei sich die jeweiligen Mischoxide in röntgenographisch phasenreiner Form bilden. Besonders geeignete Metallkationen Me sind Eisen, Titan und Aluminium sowie Kobalt und Nickel. In den Beispielen werden Komplexoxide der Formeln $LiFe_{0,1}Mn_{1,9}O_4$, $LiTi_{0,1}Mn_{1,9}O_4$ sowie $LiNi_{0,1}Mn_{1,5}O_4$ offenbart. Das Patent lehrt, dass eine gleichmäßige feine Verteilung der Ausgangskomponenten wichtig für die Herstellung phasenreiner dotierter Lithium-Mangan-Spinelle ist und dass diese feine Verteilung besonders vorteilhaft durch die gemeinsame Fällung der Ausgangskomponenten aus einer Lösung erzielt wird.

In der EP 1 035 075 A1 wird ein zweistufiges Fällungs- und Suspensionsverfahren zur Herstellung eines unter anderem mit Bor dotierten komplexen Lithium-Mangan-Spinells beschrieben. Die Verbindung weist die folgende allgemeine Formel auf:

$$Li_xMn_{(2-y)}M_{y1}B_{y2}O_4,$$

wobei M ausgewählt ist aus der Gruppe von Al, Cr, Fe, Ni, Co, Ga sowie Mg, und ferner gilt: $0,9 \leq x \leq 1,1$; $y = y_1 + y_2$,

wobei $0,002 \leq y \leq 0,5$ sowie $0 \leq y_1 < 0,5$ und $0,002 \leq y_2 \leq 0,1$ ist. Das Dotierungselement Bor wird dabei aufgrund seiner leichten Löslichkeit im zweiten Verfahrensschritt zugegeben und wird auf den Gitterplätzen des Mangans eingebaut.

Robertson et al. (J. Electrochem. Soc. 144, 10, (1997), 3500-3512) berichten für einen bordotierten Spinell der Zusammensetzung $LiMn_{1,98}B_{0,02}O_4$ von vergrößerten Kristalliten (um 1 $\mu$m) und einer verringerten spezifischen Ober-fläche nach BET (< 1 $m^2$/g). Die zugehörige rasterelektronenmikroskopische Abbildung zeigt große oktaederförmige Kristallite mit gerundeten Ecken und Kanten mit angedeuteten Kristallflächen. Allerdings wird auch von sehr schlechten elektrochemischen Eigenschaften für dieses Material berichtet. So wurde eine spezifische Kapazität von weniger als 50 mAh/g gemessen, die außerdem von Zyklus zu Zyklus stark abnimmt.

In der EP 1 204 601 B1 werden Lithium-Mangan-Spinelle für Dünnfilmelektroden beschrieben. In dem Verfahren der EP 1 204 601 B1 wird der erhaltene Lithium-Mangan-Spinell in Form von Agglomeraten in oxidierender Atmosphäre bei 450°C bis 900°C gesintert, wobei als Sinterhilfsmittel, bezogen auf das Gewicht der eingesetzten Feststoffe, 0,1 bis 3 % Boroxid oder Borsäure zugegeben werden können, um eine höhere Festigkeit der Agglomerate zu erreichen. Ein Einfluss der Borverbindungen auf die Kristallinität des Spinells wird nicht beschrieben.

In der EP 0 993 058 A1 wird eine Lithiumsekundärbatterie beschrieben, deren Aktivmaterial der positiven Elektrode im Wesentlichen aus Lithium und Mangan aufgebaut ist und eine kubische Spinellstruktur aufweist. In einem Vergleichsbeispiel wird mit Bor dotiertes $LiMn_2O_4$ als Elektrodenmaterial verwendet. Die Herstellung dieses Elektroden-materials erfolgt, indem pulverförmiges $Li_2CO_3$, $MnO_2$ und $B_2O_3$ im molaren Verhältnis Li : Mn B = 1 : 2 : 0,03 vermischt und die erhaltene Mischung in einer oxidierenden Atmosphäre für vierundzwanzig Stunden bei 800°C kalziniert wird. Es werden Partikel erhalten, welche eine deformierte Oktaedergestalt mit ebenen Kristallflächen aufweisen, wobei die Kanten und Ecken der Kristalle abgerundet sind.

In der JP 2001-48545 wird ein Verfahren zur Herstellung eines komplexen bordotierten Lithium-Manganoxids mit Spinellstruktur beschrieben, wobei eine Lithiumverbindung und eine Manganverbindung in Anwesenheit einer Borverbindung in flüssiger Phase zur Reaktion gebracht werden. Das Dotierungselement Aluminium wird dabei in Form einer festen Verbindung eingesetzt. Es werden annähernd kugelförmige granulierte Teilchen mit einem durchschnittli-chen Teilchendurchmesser von 15 $\mu$m erhalten.

Die EP 1 136 446 A2 offenbart beschichtete Lithiumkomplexoxidpartikel und Verfahren zu deren Herstellung. Die Beschichtung, die als eine einzige oder als mehrere gleiche oder verschiedene Lagen ausgebildet sein kann, soll die Eigenschaften von elektrochemischen Zellen, bei denen eine Kathode aus dem erfindungsgemäßen beschichteten Lithiummanganoxid-Material besteht, verbessern. Eine Dotierung mit zusätzlichem Lithium (überstöchiometrisches Lithium) ist zwar in der Gesamtoffenbarung beschrieben, jedoch nicht explizit offenbart. Typische Beschichtungen werden mit Alkali-Boraten sowie Bor-Lithium-Komplexsalzen erhalten.

P. Strobel et al. in "Cation Ordering in Substituted LiMn2O4 Spinels", Mat. Res. Soc. Symp. Vol. Proc. 756 beschreiben den Einfluss von verschiedenen dreiwertigen und zweiwertigen Metallkationen als Dotierungsmittel, die die 16d Mangangitterplätze besetzen, auf die elektronischen Eigenschaften derartiger dotierter Lithium-Mangan-Spinelle. Insbesondere wurde hier versucht, genau ein Viertel der oktaedrischen Kationen (16 e) zu ersetzen und es wurde gezeigt, dass dies für Magnesium und Zink in einer Überstruktur mit einer primitiven kubischen Symmetrie resultiert. Im Falle von Zink wurde eine weitere Gitterverzerrung an der tetraedrischen 8a-Stelle durch FTIR-Spektroskopie nachgewiesen.

Die DE 199 13 925 A1 offenbart überstöchiometrische Lithium-Mangan-Spinelle. Die Lithium-Mangan-Spinelle in dieser Patentanmeldung gehorchen der allgemeinen Formel Li $(Mn_{2-x}Li_x)O_4$, wobei x $0 < x \leq 0,8$ ist, die durch ein Sprühpyrolyseverfahren erhalten werden können. Lithium wird dabei anstelle von Mangan auf dessen 16d Gitterplätzen eingebaut, allerdings ist die Lithiumdotierung auf den Bereich $0 < x \leq 0,05$ beschränkt, da sich außerhalb dieses Bereiches die Zykluscharakteristik von Kathoden, die dieses Material enthalten aufgrund des Jahn-Teller-Effektes gegenüber den nicht substituierten Lithium-Mangan-Spinellen verschlechtert.

Die US 7,217,406 beschreibt granuläre Teilchen eines Lithium-Mangan-Oxids zur Verwendung als Material in Sekundärbatterien, bei dem Bor, insbesondere $H_3BO_3$, als so genanntes "Flussmittel" zugegeben wird. Bor wird dabei an die Stelle des Mangans an dessen Gitterplätzen eingebaut.

Die Dissertation von Buhrmester (Darmstadt 2001) beschäftigt sich mit der Fehlordnung im System $Li_{1+x}Mn_{2-y}O_{4-\Delta}$ und beschreibt das strukturelle und elektronische Verhalten von mit Lithium überstöchiometrisch dotierten Lithium-Mangan-Spinellen.

In der JP 2001-48547 wird ein Lithium-Manganoxid vom Spinelltyp der Formel $Li_{(x+y)}Mn_{(2-y-p-g)}M1_pM2_qO_{(4-a)}F_a$ offenbart, wobei $1,0 \leq x < 1,2$, $0 < y \leq 0,2$, $1,0 < x + y \leq 1,2$, $0 < p \leq 1,0$, $0,0005 \leq q \leq 0,1$, $0 \leq a \leq 1,0$, M1 für mindestens ein Metallatom steht, das aus Ni, Co, Mg, Fe, Al und Cr ausgewählt ist, und M2 für mindestens ein Element steht, das aus den Elementen ausgewählt ist, deren Oxide einen Schmelzpunkt von $\leq$ 800 °C aufweisen.

Die US 2003/0054248 A1 offenbart ein elektroaktives Elektrodenmaterial zur Verwendung in Lithiumionen-Sekundärzellen, das überwiegend Li-Mn-Verbundoxidteilchen mit einer Spinellstruktur umfasst, wobei die Teilchen des elektroaktiven Materials eine mittlere Porosität von 15% oder weniger, wobei die Porosität mittels der folgenden Formel berechnet wird:

$$Porosität \ (\%) \ = \ (A/B) \ x \ 100$$

wobei A für eine Gesamtquerschnittsfläche der in einem Querschnitt eines Sekundärteilchens enthaltenen Poren steht und B für eine Querschnittsfläche eines Sekundärteilchens steht, eine Klopfdichte von 1,9 g/ml oder mehr, eine Kristallitgröße von 400-960 A und eine Gitterkonstante von 8,240 A oder weniger aufweisen.

Lithiumsekundärbatterien werden zunehmend auch für Anwendungen eingesetzt, in welchen eine lange Zyklen-Lebensdauer, eine hohe Strom-Belastbarkeit und hohe Sicherheit bei Missbrauch oder Fehlfunktion gefordert werden. Solche Anforderungen müssen beispielsweise für Speicherbatterien in Hybridfahrzeugen erfüllt werden, welche neben einem üblichen Verbrennungsmotor einen Elektromotor aufweisen. Derartige Batterien müssen zudem auch günstig herzustellen sein. Die Herstellkosten werden dabei von sämtlichen Komponenten der Batterien beeinflusst.

Der Erfindung lag daher die Aufgabe zugrunde, ein Material insbesondere ein einen Lithium-Mangan-Spinell enthaltendes Material zur Verfügung zu stellen, das als Elektrodenmaterial insbesondere in Sekundärlithiumionenbatterien Verwendung finden kann und gute Ladecharakteristika aufweist.

Diese Aufgabe wird gelöst durch ein Mischoxid enthaltend

a) einen gemischt substituierten Lithium-Mangan-Spinell, bei dem ein Teil der Mangan-Gitterplätze durch Lithium-Ionen besetzt ist, und

b) eine Bor-Sauerstoff-Verbindung ausgewählt aus einem Boroxid, einer Borsäure oder deren Salzen, wobei das Mischoxid dadurch gekennzeichnet ist, dass das Mischoxid ein homophasiger homöotyper Mischkristall ist, der die Bestandteile a) und b) umfasst, wobei der Bestandteil b) in der gleichen Phase wie der Bestandteil a) vorliegt.

Überraschenderweise wurde gefunden, dass das erfindungsgemäße Mischoxid verbesserte elektrochemische Eigenschaften gegenüber einem nicht-dotierten oder mit Fremdatomen wie Zn, Mg, Cu, Al dotierten (gemisch substituierten) Lithium-Mangan-Spinell aufweist, aber auch gegenüber einem nur mit Lithium überstöchiometrisch dotierten Lithium-Mangan-Spinell bzw. einem derartigen Spinell, der mit weiteren Fremdatomen dotiert ist.

Der Begriff "ein Teil" ist in der nachstehenden Formel I durch den Zahlenwert für den Index c näher erläutert.

Der Begriff "Mischoxid" bezeichnet erfindungsgemäß einen homophasigen homöotypen Mischkristall aus den beiden Bestandteilen (z.B. Hollemann-Wiberg, Lehrbuch der Anorganischen Chemie, 102. Auflage, de Gruyter 2007, S. 130-131) und soll verdeutlichen, dass das Bor der Bor-Sauerstoffverbindung kein Dotierungselement für die 16 d Mangangitterplätze im Lithium-Mangan-Spinell ist und diese Plätze nicht einnimmt. In diesem Fall würde die Verbindung ein sogenanntes "komplexes" Oxid sein.

Der Begriff "gemischt substituiert" bedeutet, dass neben (überstöchiometrischen) Lithium sich wenigstens ein weiteres Metall auf den 16 d Gitterplätzen des Mangans, das von Mangan verschieden ist, befindet.

Bestandteil a) des erfindungsgemäßen Mischoxids, der Lithium-Mangan-Spinell, wird typischerweise auch als sogenannter "überstöchiometrischer" Lithium-Mangan-Spinell bezeichnet.

Insbesondere weist das erfindungsgemäße homophasige Mischoxid eine geringere BET-Oberfläche als vergleichbare, mit Lithium und/oder mit Metallen bzw. Übergangsmetallen dotierte Lithium-Mangan-Spinelle bzw. reine Lithium-Mangan-Spinelle auf, nämlich eine BET-Oberfläche von $< 4 \ m^2/g$, bevorzugt $< 2 \ m^2/g$ und bevorzugter von $< 1 \ m^2/g$ und am meisten bevorzugt $< 0,5 \ m^2/g$, wodurch auch die Manganauflösung im Elektrolyten einer entsprechenden Zelle deutlich verringert wird, da die BET-Oberfläche mit der Manganauflösung im Elektrolyten korreliert ist.

Die Beständigkeit gegenüber einer Auflösung im Elektrolyten wird somit durch das erfindungsgemäße Mischoxid, d.h. insbesondere also durch das Vorhandensein der Bor-Sauerstoffbindung erhöht (*vide infra*).

Darüber hinaus werden für das erfindungsgemäße Mischoxid sehr schmale Reflexbreiten in Röntgendiffraktionsspektren erhalten, da erfindungsgemäß überraschenderweise sehr große Kristallite des Mischoxides erhalten werden. Die großen Kristallite führen zu einer verminderten Oberfläche des Mischoxids, wodurch die Auflösung im Elektrolyten weiter vermindert und auch die Klopfdichte (oder anders ausgedrückt: Verdichtung) gesteigert wird. Im Vergleich zu einem reinen Lithium-Mangan-Spinell ($LiMn_2O_4$) wird eine Verbesserung der Klopfdichte von 1,23 g/cm³ auf bis zu 2,03 g/cm³ für das erfindungsgemäße Mischoxid beobachtet. Unter dem Begriff "Klopfdichte" wird vorliegend die Pulververdichtung durch Einwirkung einer äußeren Presskraft ("packing force") einer Probe des jeweiligen Materials verstanden, ausgehend von einem ursprünglichen Schüttvolumen $V_o$ der Probe. Die Einwirkung der äußeren Presskraft erfolgt auf eine mit einer vorbestimmten Menge der Probe gefüllten Behälter der anschließend wiederholt auf einer flachen Oberfläche aufschlägt (s. z. B. www.particletesting/com/density.aspx).

Außerdem sorgt das Vorhandensein der Bor-Sauerstoff-Verbindung im erfindungsgemäßen Mischoxid überraschenderweise für eine deutlich erhöhte Homogenität des Übergangsmetalleinbaus im Lithium-Mangan-Spinell gegenüber einer Dotierung ohne das Vorhandensein einer Bor-Sauerstoff-Verbindung, so dass insbesondere ein homogener gleichmäßiger Einbau von beispielsweise Aluminium, Zink etc. auf den 16 d Mangangitterplätzen erfolgt. Dies führt ebenfalls zu deutlich verbesserten elektrochemischen Eigenschaften.

Es wurde im Rahmen der vorliegenden Erfindung eine Verbesserung der Zyklenstabilität um bis zu ca. 20 % bei einer Elektrode enthaltend das erfindungsgemäße Mischoxid verglichen mit einer Elektrode enthaltend nur reinen dotierten bzw. undotierten Lithium-Mangan-Spinell festgestellt.

Bevorzugt sind, wie schon vorstehend kurz ausgeführt, im Lithium-Mangan-Spinell des Mischoxids weitere Mangan-Gitterplätze (16 d Position) durch mindestens ein Metallion, ausgewählt aus der Gruppe bestehend aus Al, Mg, Zn, Co, Ni, Cu und Cr bzw. Mischungen davon besetzt bzw. substituiert, so dass eine große Vielfalt an gemischt substituierten überstöchiometrischen Lithium-Mangan-Spinellen in dem erfindungsgemäßen Mischoxid zur Verfügung gestellt werden können, die insbesondere auch im Hinblick auf die Zyklenstabilität optimiert werden können. Wie schon gesagt, führt das Vorhandensein der Bor-Sauerstoffverbindung zu einem äußerst homogenen Einbau dieser Metalle auf den Mangan-Gitterplätzen.

Ein Teil der Lithium-Ionen auf den 8a-Tetraeder-Plätzen ist weiter durch ein Metall-Ion ausgewählt aus der Gruppe bestehend aus Zn, Mg und Cu substituiert, wodurch die elektrochemischen Eigenschaften des erfindungsgemäßen Mischoxids noch weiter präzise eingestellt werden können.

Erfindungsgemäß ist die Bor-Sauerstoff-Verbindung aus einem Boroxid, einer Borsäure oder deren Salzen ausgewählt.

Bevorzugt ist die Bor-Sauerstoff-Verbindung im erfindungsgemäßen Mischoxid ein Boroxid oder eine Borsäure, ganz besonders bevorzugt $B_2O_3$ oder $H_3BO_3$. Weitere erfindungsgemäß einsetzbare Vertreter dieser Verbindungsklassen sind $(BO)_x$, $BO$, $B_2O$ sowie $H_2BO_2$ und $HBO$. In ebenfalls bevorzugten Weiterbildungen der vorliegenden Erfindung können auch Borate, d.h. die Salze der Orthoborsäure ($H_3BO_3$) und der Metaborsäure ($H_2BO_2$) verwendet werden, bevorzugt Monoborate. In weniger bevorzugten Ausführungsformen können auch Oligo- und Polyborate verwendet werden. Ganz besonders bevorzugt sind Alkalimetallmetaborate $M_2BO_2$, insbesondere $Li_2BO_2$. Zur Struktur und Chemie der Bor-Sauerstoff-Verbindungen wird im Einzelfall auf Hollemann-Wiberg, Lehrbuch der Anorganischen Chemie, de Gruyter, Berlin 102. Auflage, 2007, S. 1104-1110 verwiesen.

Überraschenderweise wurde gefunden, dass das erfindungsgemäße Mischoxid gegenüber reinen dotierten bzw. nicht-dotierten Lithiummanganspinellen ohne das Vorhandensein von Bor-Sauerstoff-Verbindungen zusammengefasst folgende Vorteile aufweist:

- Das erfindungsgemäße Mischoxid hat eine stark verringerte BET Oberfläche von < 0.5 $m^2$/g, wobei die BET Oberfläche mit der Manganauflösung im Elektrolyten korreliert.
- Das erfindungsgemäße Mischoxid weist eine erhöhte Klopfdichte auf (Steigerung von 1.23 $g/cm^3$ auf 2.03 $g/cm^3$).
- Das erfindungsgemäße Mischoxid weist schmale Reflexbreiten im XRD Spektrum und große Kristallite auf.
- Die Homogenität des Dotierungsmetalleinbaus im Spinell des Mischoxids ist gegenüber dotiertem Lithium-Mangan-Spinell des Standes der Technik deutlich verbessert.
- Elektrochemisch wurde gegenüber dotierten Lithium-Mangan-Spinell des Standes der Technik eine Verbesserung der Zyklenstabilität des erfindungsgemäßen Mischoxids festgestellt.

Der Lithium-Mangan-Spinell des Mischoxids enthält, wie schon vorstehend gesagt, das Lithium auf einem Teil der Mangangitterplätze (Überstöchiometrie). Die Dotierungsmetallionen sind dabei gleichmäßig im Kristall verteilt. Dies zeigt sich beispielsweise in der Oxidationsstufe des Mangans sowie im Röntgenbeugungsspektrum (s. Beispiele weiter unten).

Ferner wurde auch gefunden, dass mit zunehmender Menge an Bor-Sauerstoff-Verbindung im Mischoxid auch die Lithiummenge im erfindungsgemäßen Mischoxid erhöht werden muss, um Elektroden mit elektrochemisch besonders vorteilhaften Eigenschaften herstellen zu können. So muss zusätzliches Li im Molverhältnis f = Li/B von 1 bis 4 zu 1 zugegeben werden. Vorzugsweise beträgt dieses Verhältnis 1 bis 3 zu 1 und besonders bevorzugt 1,5 bis 3 zu 1.

Die allgemeine Formel des erfindungsgemäßen Mischoxids kann wie folgt wiedergegeben werden:

$$[(Li_{1-a}M_a)(Mn_{2-c-d}Li_cN_d)O_x] \cdot b(B_zO_yH_uX_v) \qquad (I)$$

wobei gilt:

- $0 \leq a < 0,1$;
- $d < 1,2$
- $3,5 < x < 4,5$;
- $0,01 < c < 0,06$

    z = 1, 2 oder 4
    y = 1, 2, 3 oder 7

u = 0, 1, 2 oder 3
v = 0, 1, 2 oder 3
0,01 < b < 0,5

- M zumindest ein Element aus der Gruppe von Zn, Mg und Cu ist;
- N zumindest ein Element aus der Gruppe von Al, Mg, Co, Ni, Cu und Cr ist;
- X zumindest ein Element aus der Gruppe Li, Na, K ist.

In ganz besonders bevorzugten Weiterbildungen kann die obengenannte Formel wie folgt wiedergegeben werden:

$$[(Li_{1-a}M_a)(Mn_{2-c-d}Li_cN_d)O_x] \cdot (b\ B_2O_3 \cdot f{*}b\ Li_2O) \qquad (II)$$

wobei gilt:

- $0 \leq a < 0,1$;
- $d < 1,2$
- $3,5 < x < 4,5$;
- $0,01 < c < 0,06$
- $0 < b < 0,05$
- $1 < f < 4$;
- M zumindest ein Element aus der Gruppe von Zn, Mg und Cu ist;
- N zumindest ein Element aus der Gruppe von Al, Mg, Co, Ni, Cu und Cr ist.

Die Menge an Bor-Sauerstoff-Verbindung im Mischoxid wird so gewählt, dass der oben definierte Formelkoeffizient b zwischen 0,01 und 0,05, bevorzugt zwischen 0,01 und 0,05, ganz besonders bevorzugt zwischen 0,0025 und 0,025 und noch mehr bevorzugt zwischen 0,005 und 0,0025 beträgt. Ein Koeffizient von b = 0,001 entspricht dabei einem Gewichtsanteil von ungefähr 0,5 Gew.-% an Bor-Sauerstoff-Verbindung im Lithium-Mangan-Spinell enthaltenden Mischoxid.

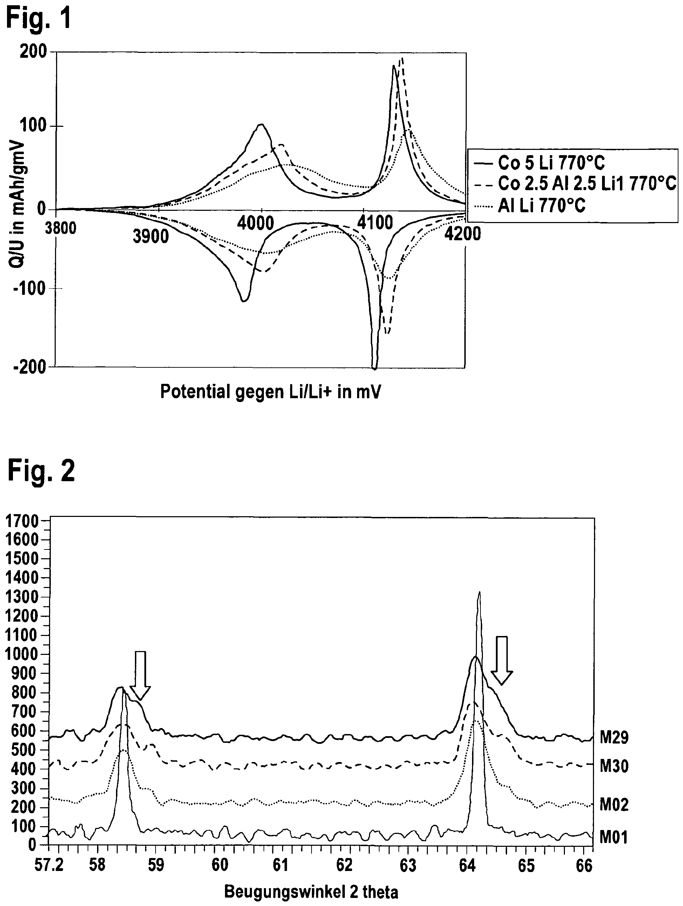

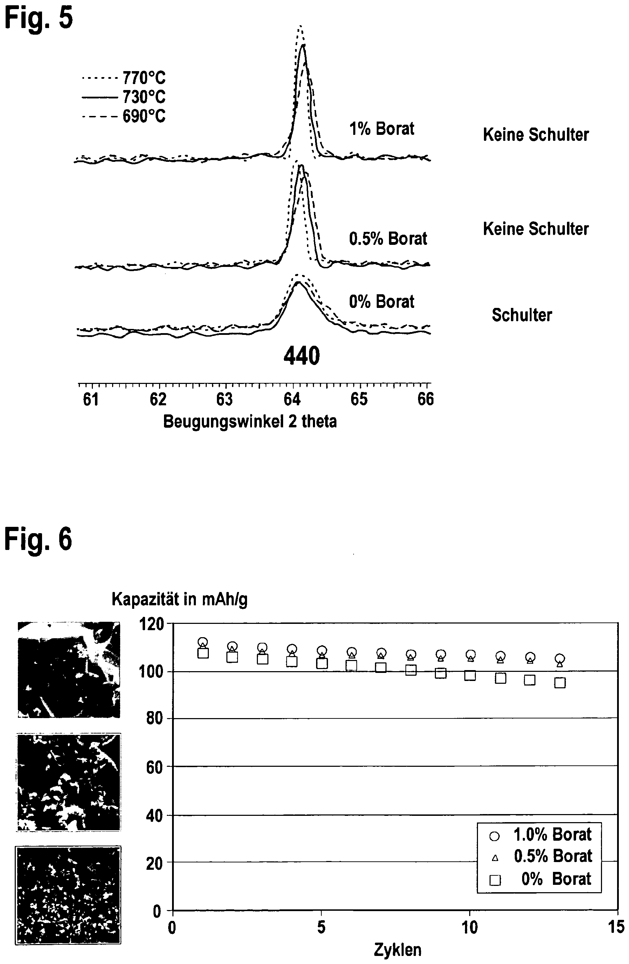

Wie bereits weiter oben erläutert, weist der Lithium-Mangan-Spinell des erfindungsgemäßen Mischoxids eine sehr gleichmäßige Verteilung der Dotierungselemente N im Kristallgitter auf. Ferner zeigt das erfindungsgemäße Mischoxid eine sehr hohe Phasenreinheit, was sich auch im Röntgenbeugungsspektrum niederschlägt. Vorzugsweise weist das erfindungsgemäße Mischoxid in einem Röntgendiffraktogramm bei einem Beugungswinkel von 2 $\theta$ im Bereich von 63,5 bis 65° ein Signal auf, bei welchem das Verhältnis der Linienbreiten $B_{10}$ gemessen in 10 % der Signalhöhe zur Linienbreite $B_{50}$ gemessen in 50 % der Signalhöhe, von weniger als 2,0, vorzugsweise weniger 1,8 auf. Insbesondere zeigt das Beugungssignal keine Schulter, was auf eine hohe Phasenreinheit hinweist (s.a. Figuren 1 und 5).

Das überstöchiometrische Lithium ist, wie schon gesagt, im erfindungsgemäßen Lithium-Mangan-Spinell auf Gitterplätzen des Mangans eingebaut. Dies zeigt sich beim Oxidationsgrad des Mangans. Vorzugsweise weist das Mangan des Spinells im erfindungsgemäßen Mischoxid einen Oxidationsgrad, bestimmt durch Cerimetrie, im Bereich von 3,60 bis 3,69, auf.

Das erfindungsgemäße Mischoxid weist vergleichsweise große Partikel auf, wobei der im Mischoxid enthaltene Lithium-Mangan-Spinell wenig Fehlordnungen aufweist. Dies resultiert vorteilhafterweise in einer geringen BET-Fläche. Vorzugsweise weist das erfindungsgemäße Mischoxid eine BET-Fläche, bestimmt nach DIN 66132, von weniger als 4 $m^2/g$ auf.

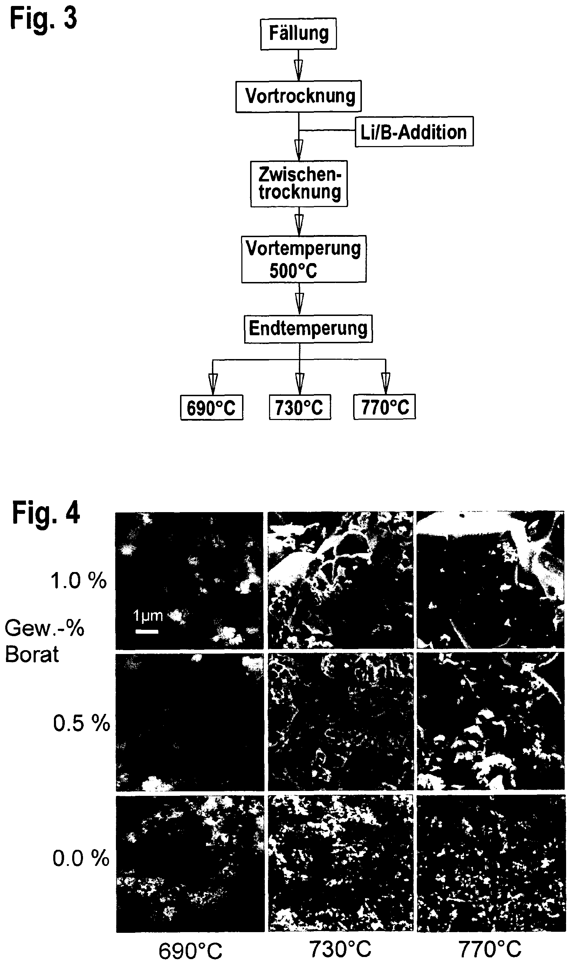

Das erfindungsgemäße Mischoxid weist eine relativ hohe Partikelgröße auf. Vorzugsweise beträgt die Größe der Primärkristallite mindestens 0,5 $\mu$m, vorzugsweise größer als 1 $\mu$m, am meisten bevorzugt im Bereich zwischen 1 und 3 $\mu$m. Die Größe der Primärkristallite lässt sich unter dem Elektronenmikroskop bestimmen (s.a. Figur 4).

Es wird ein Anteil von Dotierungselementen N bevorzugt, bei dem der Wert für d im Bereich von 0,05 bis 0,2 liegt. Besonders bevorzugt ist ein Wert für d im Bereich zwischen 0,08 und 0,15. Vorzugsweise wird Aluminium als Dotierungselement N des erfindungsgemäßen Mischoxides verwendet. Alternativ ist Magnesium ein weiter bevorzugtes Dotierungselement N, bzw. Mischungen aus Aluminium und Magnesium.

Eine Sonderstellung nehmen sehr stark mit Co und Ni dotierte sogenannte Hochvoltspinelle ein, für welche d im Falle von Co vorzugsweise 1 $\pm$ 0,2 beträgt und im Falle von Nickel 0,5 $\pm$ 0,1.

An Dotierungselementen M wird ein Anteil bevorzugt, welcher einem Wert von a von 0,005 bis 0,02 entspricht. Besonders bevorzugtes Dotierungselement M ist Zink.

Das erfindungsgemäße Mischoxid eignet sich sehr gut als Elektrodenmaterial für die Herstellung sekundärer Lithiumbatterien. Gegenstand der Erfindung ist daher auch eine Elektrode, umfassend einen elektrisch leitfähigen Träger, auf welchem das erfindungsgemäße Mischoxid aufgetragen ist.

Der Erfindung lag weiter als Aufgabe zugrunde, ein Verfahren zur Herstellung von Mischoxiden enthaltend einen dotierten oder nicht-dotierten Lithium-Mangan-Spinell zur Verfügung zu stellen, welches wirtschaftlich durchgeführt werden kann, und mit welchem ein Lithium-Mangan-Spinell enthaltendes Mischoxid erhalten werden kann, das als Elektrodenmaterial in leistungsfähigen Lithium-Sekundärbatterien verwendet werden kann.

Diese Aufgabe wird gelöst durch ein Verfahren zur Herstellung eines Mischoxids enthaltend einen gemischt dotierten überstöchiometrischen Lithium-Mangan-Spinell gemäß obiger Definition, wobei

(a) zumindest eine Lithiumkomponente, eine Mangankomponente, eine Borkomponente, eine Komponente enthaltend N, wobei N ausgewählt ist aus der Gruppe von Al, Mg, Co, Ni, Cu und Cr, und/oder eine Komponente enthaltend M, wobei M ausgewählt ist aus Zn, Mg und Cu bereitgestellt wird;

(b) ein erster Anteil einer festen Mischung hergestellt wird, indem ein Teil der Komponenten aus (a) in trockener, pulverförmiger Form vermischt wird;

(c) ein zweiter Anteil einer flüssigen Mischung hergestellt wird, welcher einen Anteil der Komponenten aus (a) in gelöster Form und/oder als Suspension enthält,

(d) der erste Anteil (b) und der zweite Anteil (c) vermischt werden;

(e) der in (d) erhaltenen Mischung das Lösungsmittel entzogen wird,

(f) die in (e) erhaltene Mischung bei einer Temperatur von mehr als 300°C kalziniert wird,
wobei die stöchiometrischen Mengen der Komponenten des ersten Anteils (b) und des zweiten Anteils (c) so ausgewählt sind, dass sich ein Mischoxid der folgenden Formel ergibt:

$$[(Li_{1-a}M_a)(Mn_{2-c-d}Li_cN_d)O_x] \cdot b\ (B_zO_yH_uX_v)$$

wobei gilt:

- $0 \leq a < 0,1$;
- $d < 1,2$
- $3,5 < x < 4,5$;
- $0,01 < c < 0,06$

       $z = 1, 2$ oder $4$
       $y = 1, 2, 3$ oder $7$
       $u = 0, 1, 2$ oder $3$
       $v = 0, 1, 2$ oder $3$

- $0,01 < b < 0,5$
- M zumindest ein Element aus der Gruppe von Zn, Mg und Cu ist;
- N zumindest ein Element aus der Gruppe von Al, Mg, Co, Ni, Cu und Cr ist;
- X zumindest ein Element aus der Gruppe Li, Na und K ist;

wobei zusätzliches Li in einem Molverhältnis f= Li/B von 1 bis 4 zu 1 zugegeben wird.

(Es versteht sich, dass natürlich durch entsprechende Wahl der Mengen der Ausgangstoffe auch ein Mischoxid gemäß Formel II erhältlich ist)

Beim erfindungsgemäßen Verfahren zur Herstellung eines Mischoxids enthaltend einen dotierten überstöchiometrischen Lithium-Mangan-Spinell und eine Bor-Sauerstoff-Verbindung werden zunächst je mindestens eine Verbindung der Elemente Li, Mn und Bor (hier natürlich eine Bor-Sauerstoff-Verbindung) und eine Verbindung eines Metalls N, wobei N ausgewählt ist aus der Gruppe von Al, Mg, Co, Ni, Cu und Cr und/oder eine Verbindung eines Metalls M, wobei M ausgewählt ist aus Zn, Mg und Cu, bereitgestellt. Die Ausgangskomponenten, vorzugsweise der Lithium- oder der Bor-Sauerstoff-Komponente können in fester Form bereitgestellt werden. Die Bor-Sauerstoff-Komponente ist eine der vorstehend beschriebenen Bor-Sauerstoff-Verbindungen.

Die festen Komponenten werden vorzugsweise in vorgemahlener Form eingesetzt. In den Experimenten hat sich gezeigt, dass die Partikelmorphologie des Mischoxids durch die Partikelmorphologie einer eingesetzten festen und unlöslichen Manganverbindung gezielt gesteuert werden kann. Daher wird in einer besonders bevorzugten Ausführungsform eine feste und unlösliche Manganverbindung eingesetzt, die zuvor auf die gewünschte Partikelgröße des Endprodukts gebracht wurde, die durch Lasergranulometrie bestimmt wird. Es geht hierbei im Wesentlichen um die Begrenzung des sogenannten Überkorns, welches Probleme bei der Verarbeitung zu Dünnfilmelektroden hervorruft. Der D95-Wert einer eingesetzten festen Manganverbindung sollte daher unter 60 $\mu$m, vorzugsweise unter 30$\mu$m liegen. Auf die Bestimmungsmethode wird weiter unten eingegangen.

Die Verbindungen werden vorzugsweise je einzeln in Form einer Metallverbindung bereitgestellt (also als sogenannte binäre Verbindung, in der allerdings auch mehrere Anionen vorhanden sein können, jedoch nur ein (Metall-)Kation), da dies eine problemlose Dosierung zulässt. Es ist aber auch möglich Verbindungen einzusetzen, welche mehrere der Metalle enthalten, also sogenannte polynäre Verbindungen mit mehreren verschiedenen (Metall-)Kationen.

Mindestens eine Ausgangskomponente, nämlich vorzugsweise diejenige eines reaktionsträgen Dotierungselementes wie Aluminium, Magnesium, Zink, Kobalt oder Nickel wird in gelöster Form bereitgestellt, um die feine Verteilung in den späteren Prozessschritten zu gewährleisten. Das Lösungsmittel ist vorzugsweise Wasser.

Die Lösungsmittelmenge wird so gewählt, dass die zu lösenden Komponenten vollständig gelöst werden können. Da das Lösungsmittel in einem späteren Verfahrensschritt wieder entfernt werden muss, wird jedoch die Lösungsmittelmenge nach Möglichkeit gering gewählt. Die Lösungsmittelmenge sollte jedoch so groß gewählt werden, dass sie die festen Komponenten in Form einer Suspension oder Paste aufnehmen kann. Es können auch sämtliche Ausgangskomponenten in gelöster Form eingesetzt werden, um ideale Bedingungen für ihre feine Verteilung in den späteren Prozessschritten zu schaffen. Wegen des höheren Lösungsmittelbedarfs und wegen der Einschränkungen in der Auswahl der Rohstoffe ist dies jedoch eine weniger bevorzugte Ausführungsform.

Die für die Herstellung des Lithium-Mangan-Spinell enthaltenden Mischoxids verwendeten festen und gelösten Komponenten werden vorzugsweise in Form ihrer Nitrate, Acetate, Oxide, Hydroxide oder Carbonate bereitgestellt. Diese Verbindungen sind z. T. sehr gut in Wasser löslich.

Die lösliche Mangankomponente wird vorzugsweise aus Mangannitrat und Manganacetat ausgewählt.

Die feste Mangankomponente wird vorzugsweise aus Mangancarbonat, Manganoxid und Mangandioxid ausgewählt.

Die Borkomponente ist vorzugsweise ausgewählt aus einer Borsäure, einem Alkaliborat und einem Boroxid. Typische Vertreter von Borsäure sind $H_3BO_3$, $H_3BO_2$, von Oxiden $B_2O_3$, $(BO)_x$, $BO_2$. Ganz besonders bevorzugt sind Borsäure $H_3BO_3$ und Boroxid $B_2O_3$ sowie Lithium- bzw. Natriumborate.

Die genannten Mangan- und Borkomponenten können einzeln oder im Gemisch verwendet werden.

Die stöchiometrischen Mengen der Komponenten werden so ausgewählt, dass sie in einem molaren Verhältnis vorliegen, welches einem Mischoxid aus einem dotierten Lithium-Mangan-Spinell und einer Bor-Sauerstoff-Verbindung der folgenden Formel entspricht:

$$[(Li_{1-a}M_a)(Mn_{2-c-d}Li_cN_d)O_x]\cdot b\ (B_zO_yH_uX_v) \qquad (I)$$

wobei gilt:

- $0 \leq a < 0,1$;
- $d < 1,2$
- $3,5 < x < 4,5$;
- $0,01 < c < 0,06$

     $z = 1, 2$ oder $4$
     $y = 1, 2, 3$ oder $7$
     $u = 0, 1, 2$ oder $3$
     $v = 0, 1, 2$ oder $3$
     $0,01 < b < 0,5$

- M zumindest ein Element aus der Gruppe von Zn, Mg und Cu ist;
- N zumindest ein Element aus der Gruppe von Al, Mg, Co, Ni, Cu und Cr ist;
- X zumindest ein Element aus der Gruppe Li, Na, K ist.

In ganz besonders bevorzugten Weiterbildungen kann die obengenannte Formel wie folgt wiedergegeben werden:

$$[(Li_{1-a}M_a)(Mn_{2-c-d}Li_cN_d)O_x]\cdot(b\ B_2O_3 \cdot f^*b\ Li_2O) \qquad (II)$$

wobei gilt:

- 0 ≤ a < 0,1;
- d < 1,2
- 3,5 < x < 4,5;
- 0,01 < c < 0,06
- 0 < b < 0,05
- 1 < f < 4;
- M zumindest ein Element aus der Gruppe von Zn, Mg und Cu ist;
- N zumindest ein Element aus der Gruppe von Al, Mg, Co, Ni, Cu und Cr ist.

Die Komponenten werden daraufhin vermischt, wobei die Vermischung in beliebiger Reihenfolge durchgeführt werden kann. In einer verfahrenstechnisch bevorzugten Vorgehensweise wird zuerst die flüssige Teilmischung vorgelegt und die feste pulverförmige Teilmischung unter Rühren hinzugefügt, wobei eine Suspension oder Paste erhalten wird. Es ist dabei möglich, dass ein bestimmtes Element entweder nur im festen Anteil oder nur im flüssigen Anteil vertreten ist. Es kann aber auch ein bestimmtes Element auf beide Anteile verteilt sein. So kann es vorteilhaft sein, dass der Mangananteil sowohl als feste Verbindung, als auch als gelöste Verbindung zugegeben wird, um sowohl die Partikelmorphologie des Endproduktes zu steuern, als auch die homogene Verteilung der reaktionsträgen Dotierungselemente zu fördern. Die Mischung kann in einem üblichen Mischer hergestellt werden.

Die Vermischung erfolgt dabei unter Bedingungen, dass im Wesentlichen keine weitere Zerkleinerung der unlöslichen festen Komponenten eintritt. Die Vermischung der Komponenten kann bei Temperaturen von 0° bis 100°C erfolgen, vorzugsweise aber zwischen Raumtemperatur und 50° C. Je nach Mischintensität des verwendeten Mischaggregates wird die Vermischung während einer Dauer von wenigen Minuten bis mehreren Stunden durchgeführt. Der Mischvorgang läuft vorzugsweise unter chemischen Bedingungen ab, bei denen Verbindungen der gelösten reaktionsträgen Elemente zur Fällung gebracht werden. Dies kann zum Beispiel durch Änderung des pH-Wertes durch eine der zugesetzten Komponenten oder durch Reaktion zweier gelöster oder einer gelösten und einer festen Komponente untereinander erfolgen. Es ist aber auch möglich, die gelösten reaktionsträgen Komponenten erst bei der anschließenden Trocknung zur Fällung zu bringen, was jedoch weniger vorteilhaft für deren gleichmäßige, feine Verteilung ist.

Nach Abschluss des Vermischens wird der Mischung das Lösungsmittel entzogen. Dabei können an sich beliebige Verfahren angewandt werden. Beispielsweise kann das Lösungsmittel durch Gefriertrocknen oder Sprühtrocknen entfernt werden. Das Lösungsmittel kann auch in der Weise entfernt werden, dass der Mischbehälter nach dem Vermischen erwärmt wird und das Lösungsmittel unter Rühren abdestilliert wird. Die Mischung nimmt dabei eine teigartige Konsistenz an, so dass nach Möglichkeit Maßnahmen ergriffen werden, mit welchen verhindert wird, dass sich die Mischung am Mischer oder den Wänden des Mischerbehälters festsetzt. Zum Ende des Trocknungsvorgangs kann die Mischung beispielsweise auch in einen Ofen überführt und dort bei erhöhter Temperatur restliches Lösungsmittel ausgetrieben werden. Die Temperaturen werden dabei so gewählt, dass ein möglichst gleichmäßiges Verdampfen des Lösungsmittels erreicht wird. Bevorzugt wird bei Temperaturen von weniger als 300°C getrocknet.

Nach dem Entfernen des Lösungsmittels wird die Mischung bei Temperaturen von 300°C bis 800°C an Luft kalziniert. Das Kalzinieren wird vorzugsweise zweistufig durchgeführt. Die erste Stufe wird bei einer Haltetemperatur zwischen 300°C und 600°C und für eine Dauer von 10min bis 2h Stunden durchgeführt und dient dem Austreiben gasförmiger Zersetzungsprodukte und der Bildung einer noch wenig kristallisierten und unausgereiften Spinellverbindung.

Die zweite Stufe wird als Temperstufe bei einer Haltetemperatur zwischen 600°C und 800°C, vorzugsweise zwischen 740°C und 780°C, und für eine Dauer von 1 bis 12 Stunden durchgeführt und dient dem Ausreifen der Spinellverbindung. Die Aufheizrate ist beliebig, die Abkühlrate beträgt vorzugsweise zwischen 0,5 K/min und 5 K/min. Die beiden Temperaturbehandlungen können direkt aufeinander folgen oder wahlweise durch einen zwischenzeitlichen Abkühlschritt und eine Zerkleinerungsbehandlung unterbrochen sein.

Zur Bildung eines phasenreinen und homogenen dotierten Mischoxids aus einem Lithium-Mangan-Spinell und einer Bor-Sauerstoffverbindung mit verbesserten elektrochemischen Eigenschaften ist eine feine homogene Verteilung der reaktionsträgen Dotierungskomponenten in der Precursormischung notwenig. Beim erfindungsgemäßen Verfahren wird dies durch gemeinsame Fällung dieser Komponenten aus dem gelösten Zustand gewährleistet.

Dadurch kann beispielsweise im Gegensatz zu dotierten, insbesondere bordotierten Aluminium-Mangan-Spinellen des Standes der Technik auf eine teure und energieaufwendige Hochenergievermahlung, z.B. in einer Kugelmühle, verzichtet werden. Außerdem birgt ein solches Verfahren das Risiko einer Kontamination mit dem Abrieb der Mahlwerkzeuge.

Ferner sind die gelösten und gefällten Komponenten gleichmäßig in der Mischung verteilt und werden damit auch gleichmäßig in den Spinell eingebaut, ohne dass dazu übermäßig hohe Temperaturen über einen längeren Zeitraum zur thermischen Behandlung der Mischung eingesetzt werden müssen, wie dies beispielsweise bei reinen Feststoffverfahren der Fall ist. Das erhöht die Wirtschaftlichkeit des Verfahrens durch geringeren Energieaufwand und einen größeren Durchsatz und verringert die Verluste an volatilem Lithium während der thermischen Behandlung. Ein Fällungsverfahren mit anschließender Temperaturbehandlung bei erniedrigter Haltetemperatur und Haltezeit hat jedoch den Nachteil geringer Kristallitgrößen und einer großen spezifischen Oberfläche. Das erhöht die Angriffsfläche gegenüber aggressiven Elektrolytbestandteilen.

Um diesem ungünstigen Effekt entgegenzuwirken, sieht daher die Erfindung eine zusätzliche Zugabe einer Bor-Sauerstoff-Verbindung vor, so dass ein phasenreines Mischoxid entsteht. Überraschend hat sich jedoch gezeigt, dass die Zugabe der Bor-Sauerstoff-Verbindung im erfindungsgemäßen Verfahren nicht nur das Kristallitwachstum fördert, sondern, wie vorstehend schon ausgeführt, auch die homogene Verteilung der übrigen Dotierungselemente. Die durch Auswertung der Pulver-Röntgenbeugungsprofile des Endproduktes in der Spinellstruktur qualifizierbare Verteilung der Dotierungselemente ist beim erfindungsgemäßen Verfahren sowohl bei Einsatz ausschließlich gelöster Ausgangskomponenten vollkommen homogen, als auch bei überwiegendem Einsatz fester Ausgangskomponenten, sofern zusätzlich eine Bor-Sauerstoff-Verbindung zugegeben wird.

Überraschenderweise führt das erfindungsgemäße Verfahren zu einem phasenreinen Mischoxid, bei dem Bor - wie schon vorstehend ausgeführt - keine Gitterplätze des Mangans besetzt ("Dotierung" bzw. "Substitution"), sondern als in der gleichen Phase wie der dotierte Lithium-Mangan-Spinell als Bor-Sauerstoff-Verbindung vorliegt. Dieser Effekt war bislang unbekannt.

Durch das erfindungsgemäße Verfahren und die Mischoxidbildung ist es möglich, röntgenografisch phasenreine und homogen dotierte Lithium-Mangan-Spinelle herzustellen, ohne vollständiges Lösen und Fällen der Ausgangskomponenten, ohne Hochenergievermahlung und ohne sehr lange Temperaturbehandlungen bei hoher Temperatur. Damit ist das Verfahren sehr wirtschaftlich. Zudem fallen keine Abwässer und keine Abfälle und Koppelprodukte an.

Außerdem hat sich überraschend gezeigt, dass eine wachsende Borzugabe einen dazu angepasst steigenden Lithiumüberschuß (Überstöchiometrie) erforderlich macht, um negative Begleiteffekte zu kompensieren.

Mit dem erfindungsgemäßen Verfahren können also die erfindungsgemäßen Mischoxide enthaltend dotierte Lithium-Mangan-Spinelle und eine Bor-Sauerstoff-Verbindung hergestellt werden, welche eine vergleichsweise große Kristallitgröße und eine niedrige BET-Oberfläche aufweisen. In den Spinellen sind die Dotierungsmittel, die Metalle der durch N und M gebildeten Gruppe, gleichmäßig auf den Mangangitterplätzen im Spinell verteilt. Es werden sehr gleichmäßige Kristallite erhalten, welche wenig Gitterfehler aufweisen.

Weiterhin ist Gegenstand der Erfindung eine Sekundärbatterie, insbesondere eine wiederaufladbare Sekundärbatterie, welche eine Elektrode, enthaltend das erfindungsgemäße Mischoxid als Elektrodenmaterial ("Aktivmaterial"), insbesondere Kathodenmaterial umfasst.

Die Erfindung ist weiter anhand von Beispielen sowie unter Bezugnahme auf die beigefügten Figuren näher erläutert.

Die Figuren zeigen dabei im Einzelnen:

Figur 1: die Auftragung von dQ/dE gegen E für verschiedene Co/Al/Li Gehalte von Lithiummanganspinellen

Figur 2: XRD Spektren von erfindungsgemäßen Mischoxiden und reinen Lithiummanganspinellen im Vergleich

Figur 3: das Schema des erfindungsgemäßen Verfahrens

Figur 4: REM Aufnahmen erfindungsgemäßer Mischoxide

Figur 5: Lage, Reflexbreite und Phasenreinheit von erfindungsgemäßen Mischoxiden

Figur 6: den Einfluss der Boratzugabe auf das elektrochemische Verhalten

Figur 7: die Manganauflösung erfindungsgemäßer Mischoxide im Vergleich mit reinen Lithium-Mangan-Spinellen in mg Mn/kg

Figur 8: die Abhängigkeit der BET Oberfläche erfindungsgemäßer Mischoxidkristalle von Temperatur und Lithium-Überstöchiometrie

Figur 9: die Auftragung von dQ/dE gegen E für erfindungsgemäße Mischoxide mit unterschiedlicher Lithium-Überstöchiometrie

Figur 10: die Entladekapazitäten erfindungsgemäßer Mischkristalle im ersten Zyklus

Figur 11: die Potentialverläufe im ersten Vollzyklus erfindungsgemäßer Mischoxide

Figur 12: die Potentialverläufe im ersten Vollzyklus weiterer erfindungsgemäßer Mischoxide.

Figur 13: eine rasterelektronenmikroskopische Aufnahme eines erfindungsgemäßen Mischoxides enthaltend Lithium-Mangan-Spinell.

## Allgemeines

### Analysenmethoden:

In den folgenden Beispielen wurden die folgenden Analysenmethoden verwendet und gemäß der nachstehenden Vorschriften ausgeführt:

a) Lasergranulometrie mit einem Gerät der Firma Malvern

b) BET-Oberfläche nach DIN 66132

c) Cerimetrie (basierend auf U. R. Kunze, Grundlagen der quantitativen Analyse, Seit 207, 2. Auflage, Thieme Verlag, Stuttgart 1986). Zunächst wurde das aus einer Probe dem Mischoxid durch z.B. sauren Aufschluss erhaltene $MnO_2$ mit einem definierten Überschuss an Mohr'schem Salz in saurer Lösung umgesetzt und das unverbrauchte $Fe^{2+}$ mit $Cer^{(IV)}$ Sulfat rücktitriert, worauf über Differenzrechnung die Menge an $MnO_2$ und damit der analytische Gehalt der Probe, folglich der mittlere Oxidationsgrad ermittelt werden kann.

d) XRD Messung

Blenden (1mm/1mm/0.2mm); Strahlung: Cuk $\alpha$..Bereich: 10-80°; Schrittweite: 0.02°; Meßdauer: 5.5 sec/step

### Experimentelles:

Die verwendeten Ausgangsprodukte sind bei den folgenden Bezugsquellen kommerziell erhältlich und wurden falls nicht anders angegeben wie erhalten eingesetzt.

Mangancarbonat ($MnCO_3$) S grade: Fa. Comilog/Erachem Lithiumhydroxid-Monohydrat ($LiOH*H_2O$): Acu Pharma Borsäure ($H_3O_3$): Jäkle Chemie Aluminiumnitrat-Nonahydrat ($Al(NO_3)_3*9H_2O$): Fa. Tropitzsch Zinknitrat-Hexahydrat ($Zn(NO_3)_2*6H_2O$): Fa. Plato Mangannitrat-Lösung (50Gew%): Fa. Coremax/Taiwan

Elektroden wurden hergestellt indem 70 % erfindungsgemäßes Aktivmaterial bzw. Mischoxid, 20 % Super PLI leitfähiger Kohlenstoff der Firma Timcal und 10 % PTFE-Pulver in einem Mörser gemischt wurden, bis sich eine Flocke bildete. Die Flocke wurde im Mörser mehrfach verknetet bevor sie auf eine Dicke von 100 $\mu$m in einer Edelstahlrollenpresse ausgerollt wurde. Runde Elektrodenfolien mit einem Durchmesser von 10 mm wurden ausgestochen, über Nacht bei 200°C getrocknet und anschließend in einer Swagelock PVDF T-Zelle für elektrochemische Messungen angeordnet. Die Gegen- und Referenzelektrode bestanden aus einer Lithiummetallfolie und waren durch eine Glaswolleseparatorfolie der Firma Whatman getrennt. Als Elektrolyt wurde Merck LP30 verwendet. Die Ladungs/Entladungs/Testzyklen wurden bei einem Strom von C/20 und einer nominellen spezifischen Kapazität von 120 mA/h in einem Spannungsfenster zwischen 4,2 Volt und 2,8 Volt aufgenommen.

### Vergleichsbeispiel 1

*Herstellung eines Lithium-Mangan-Spinells der Formelzusammensetzung Li[Mn$_{1,87}$Al$_{0,10}$Li$_{0,03}$]$_2$O$_4$ ohne Zusatz einer Bor-Sauerstoff-Verbindung.*

Als Ausgangsmaterialien wurden die folgenden Komponenten bereitgestellt:

| | | |
|---|---|---|
| $MnCO_3$ | 93% | 231,13g |
| $Al(NO_3)3*9H_2O$ | 98,50% | 38,08g |
| $HNO_3$ | 65% | 70,77g |
| $LiOH*H_20$ | 96,30% | 44,88g |
| $H_2O$ | 100% | 230g |

Das Mangancarbonat und das Aluminiumnitrat-Nonahydrat werden mit einem Labor-Ankerrührer auf kleiner Stufe in das vorgelegte Wasser eingerührt bzw. gelöst. Danach wird die Salpetersäure langsam zugegeben und 10min weiter gerührt. Die Salpetersäure ist so bemessen, dass sich ca. 1/4 des Mangancarbonats als Mangannitrat in Lösung geht. Der Labor-Ankerrührer wird auf 40 UPM gestellt, um die Suspension in Schwebe zu halten. Dann wird das pulverförmige Lithiumhydroxid-Monohydrat zugegeben und der Labor-Ankerrührer für 30 min auf 100 UPM gestellt, um die stark steigende Viskosität zu kompensieren. Die erhaltene mittelbraune Paste wird in der Laborschale für 18h bei 100°C getrocknet (Einwaage 1431 g/Auswaage 261 g) und das braune Trocknungsprodukt im Handmörser zerkleinert. 51,1 g des Trocknungsproduktes wurden im Keramiktiegel für 1h bei 500°C im Kammerofen an Luft kalziniert und dabei 32,5 g eines schwarzen Pulvers erhalten. 9,0 g des Calcinationsproduktes wurden im Keramiktiegel im Kammerofen an Luft für 12 h bei 750°C gesintert mit einer Aufheizzeit von 6 h und einer Abkühlzeit von ebenfalls 6 h. Dabei wurden 8,85 g Sinterprodukt erhalten.

Vergleichsbeispiel 2

*Herstellung eines mit Aluminium bzw. Kobalt dotierten Lithium-Mangan-Spinells mit Lithium Überstöchiometrie.*

Die Herstellung der Proben erfolgt über getrenntes Einleiten einer Mangannitrat- und einer Dopandenlösung (Aluminium- und/oder Kobaltnitrat) in eine Vorlagelösung aus LiOH und $NH_3$. Die Proben werden ohne Waschprozess in einen Ofen überführt und statisch bei 160°C vorgetrocknet. Es folgt eine Vortemperung des Precursors bei 500°C. Nach Abkühlung wird das Zwischenprodukt vermörsert und in einem zweiten Temperschritt bei verschiedenen Endtemperaturen (690°C, 730°C und 770°C) in das fertige Endprodukt überführt.

Im Vergleich zum Kobalt-dotierten Produkt ist die Kristallitgröße der Aluminium-dotierten Spinelle deutlich kleiner.

Im elektrochemischen Verhalten zeigte sich bei den Co/Li haltigen Spinellen eine stärkere Ausprägung der zusätzlichen Stufen und geringere Zyklenstabilität im untersuchten Zyklenbereich. Höhere Zyklenstabilität wurde bei der Al/Li dotierten Probe gefunden.

Es wurden Spinelle mit verschiedenen Li/Mn/Co/Al Gehalten synthetisiert. Tabelle 1 zeigt die hergestellten Spinelle:

**Tabelle 1** Einfluss der Dopanden (Dotierungselemente) Al, Co und Li; die Angaben entsprechen den Anteilen an ersetzten Mn-Ionen in %

| Probe | Al | Co | Li |
|---|---|---|---|
| G1007 | 0 | 5 | 1,5 |
| G1008 | 0 | 5 | 1,5 |
| G1010 | 5 | 0 | 1,5 |
| G1011 | 5 | 0 | 1,5 |
| G1019 | 0 | 5 | 0 |
| G1020 | 5 | 0 | 0 |
| G1021 | 0 | 5 | 1 |
| G1022 | 5 | 0 | 1 |
| G1028 | 2,5 | 2,5 | 1 |

Die erhaltenen Spinelle wurden zunächst elektrochemisch charakterisiert:
Aus dem Potentialverlauf der Lade/Entladekurven lassen sich dabei wichtige Informationen u.a. über die Zyklenstabilität ziehen. Typischerweise zeigte sich im Verlauf der Lade- und Entladekurve nach etwa halber Ladung/Entladung eine Potentialstufe, die auf strukturelle Ordnungseffekte im Spinellgitter zurückzuführen ist. Je ausgeprägter und schärfer dieser Sprung ist, desto schlechter ist in der Regel die Zyklenstabilität des untersuchten Materials. Dieser Effekt gibt bereits einen Vorab-Hinweis auf die Zyklenstabilität des Materials.

Ähnliches gilt für eine zusätzliche Potentialstufe, die bei 3.1 V vs Li auftreten kann.

Die Ableitungen der Potentialkurven (dQ/dE vs E) wurden aufgetragen (Figur 1), um die Ausprägung der Potentialstufen besser vergleichen zu können. Die Maxima/Minima entsprechen hierbei den Plateaus in den Ladekurven. Je schärfer hier die Peaks ausgebildet sind, desto stärker die Stufenausprägung.

Figur 1 zeigt, dass mit zunehmendem Aluminiumgehalt in der Struktur die Peaks stärker ineinander übergehen, was einer "Verschmierung" der Potentialkurven entspricht. Dieser Effekt ist ein Kriterium für den strukturellen Einbau des Aluminiums in die Spinellstruktur. Elektrochemisch ergibt sich somit eine höhere Zyklenstabilität.

Daneben wurde auch eine Potentialerhöhung durch den Austausch von Kobalt gegen Aluminium festgestellt.

Zusätzlicher Einbau überstöchiometrischen Lithiums (auf Mangangitterplätzen) wirkt sich in der Aluminium-dotierten Probe durch noch ausgeprägtere Überlagerung der Peaks aus. Eine Verschiebung der Peak-Lage ist nicht zu erkennen.

Beispiel 1

*Herstellung eines erfindungsgemäßen Mischoxids*

Die Herstellung des erfindungsgemäßen Mischoxids erfolgte ausgehend von einem stöchiometrischen dotierten Lithium-Mangan-Spinell (Precursorwert) erhalten analog zu Vergleichsbeispiel 1. Zur Herstellung der Überstöchiometrie wurde LiOH und als Bor-Sauerstoff-Verbindung Boroxid in Form eines Gemisches von LiOH und $B_2O_3$ verwendet, Das molare Verhältnis von Li zu B betrug von 2 zu 1 bzw. f = 2,5).
Der Precursor (5 % Al (d = 0,1) und 1.5 % Li (c = 0,03) Dotierung) wurde mit verschiedenen Anteilen von LiOH und $B_2O_3$ Lösungen vermischt und gemäß dem Schema in Figur 3 umgesetzt.
Die Zugabe der Bor-Sauerstoff-Verbindung, hier dem Borat, wirkt sich auf die Morphologie, die Halbwertsbreiten der Röntgenreflexe und die BET Oberfläche der Al/Li dotierten Lithium-Mangan-Spinelle des erfindungsgemäßen Mischoxids aus.
Bereits durch einen geringen Zusatz von Borat wird ein ausgeprägter Sprung in wichtigen Eigenschaften erzielt.
Wie in Figur 4 zu sehen ist nimmt die Kristallitgröße bei Zugabe von Borat und Erhöhung der Tempertemperatur stark zu. Die größten Kristallite werden demgemäß bei einer Temperatur von 770°C und unter Zugabe von 1 Gew.-% (bevorzugt auf das Gesamtgemisch des Mischoxids) erzielt. Die BET Oberfläche und wie in Figur 5 zu sehen ist, die Halbwertsbreite der XRD Reflexe verringern sich hingegen deutlich.
Die untersuchten erfindungsgemäßen Mischoxide waren nach dem Profil der XRD Reflexe einphasig (homophasig oder homöotyp), d.h. ein vollständiger regelmäßiger Aluminiumeinbau in die Kristallstruktur hatte stattgefunden.

Beispiel 2

*XRD Spektrum des erfindungsgemäßen Mischoxids*

Das XRD Spektrum des erfindungsgemäßen Mischoxids (MO1 1 Gew.-% Borat und MO2 0,5 Gew.-% Borat), erhalten gemäß Beispiel 1, wurde mit den XRD Spektren von Al-dotierten überstöchiometrischen Lithiummanganspinellen erhältlich gemäß Vergleichsbeispiel 1 (M29 und M30) verglichen (Figur 2).
Alle Proben waren mit Li/Al im Verhältnis 1:5 dotiert. Ziel war die Untersuchung des homogenen Einbaus der Dopanden in das Kristallgitter.
Im XRD Spektrum zeigt (nach K$\alpha$2 Korrektur) ein homogen dotierter einphasiger Lithiummanganspinell des erfindungsgemäßen Mischoxids einzelne "symmetrische" Reflexe (MO1 und MO2).
Die Kurven von M 29 und M 30 zeigen (nach K$\alpha$2 Korrektur) deutlich ausgeprägte Schultern (Pfeile). Dies weist auf Mehrphasigkeit bzw. eine inhomogene Verteilung der Dopanden hin.

Beispiel 3

*Elektrochemie*

Auch elektrochemisch wirkt sich das Vorhandensein einer Bor-Sauerstoff-Verbindung, hier dem Borat, im erfindungsgemäßen Mischoxid erhalten, gemäß Beispiel 1 positiv aus. Die Zyklenstabilität nimmt, wie aus Figur 6 ersichtlich ist, mit zunehmendem Boratgehalt im Mischoxid gegenüber einem reinen Al-dotierten Lithium-Mangan-Spinell zu.

Beispiel 4

*Manganauflösung*

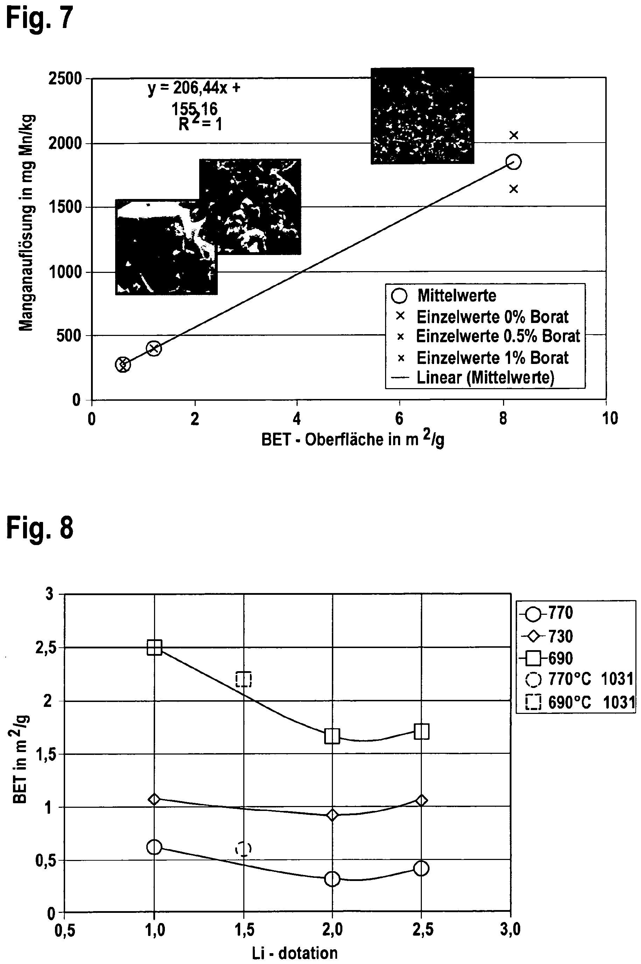

Ein Grund für die bisher mangelnde Zyklenstabilität von reinen dotierten bzw. nicht-dotierten Lithium-Mangan-Spinellen war deren Zersetzung in Elektrolyten. Um die relative Stabilität des erfindungsgemäßen Mischoxids gegenüber einer Zersetzung der Spinellkomponente in einem Elektrolyten zu überprüfen, wurden je 4 g Mischoxidpulver aus Beispiel 1 mit unterschiedlichen Mengen Borat und einem Al-dotierten Lithium-Mangan-Spinell aus Beispiel 1 in 40 g LP30 (Elektrolyten der Fa. Merck) über vier Wochen bei 40°C gelagert. Anschließend erfolgte die Analyse des Elektrolyten auf gelöstes Mangan mittels ICP. Untersucht wurden die bei 770°C getemperten Pulver.
Wie aus Figur 7 ersichtlich ist, zeigten die untersuchten Proben im relativen Vergleich eine Abnahme der Manganauflösung mit zunehmender BET Oberfläche. Erkennbar ist, dass ein reiner Lithium-Mangan-Spinell ohne den Zusatz einer Bor-Sauerstoff-Verbindung die höchste Auflösung zeigt. Die Zugabe der Bor-Sauerstoffverbindung stabilisiert also den Lithium-Mangan-Spinell im erfindungsgemäßen Mischoxid.

Beispiel 5

*Variation der Lithium-Überstöchiometrie*

In weiteren Synthesen wurde bei konstantem Al Gehalt schrittweise die Lithiumüberstöchiometrie der Spinellkomponente des Mischoxids variiert.

Gewählte Dotierungen waren Al 5 % Li 1 % (d = 0,1; c = 0,02), Al 5 % Li 2 % (d = 0,1; c = 0,04) sowie Al 5 % Li 2.5 % (d = 0,1; c = 0,05). Jede der Proben wurde ohne sowie mit 1 Gew.-% einer $LiOH/B_2O_3$ Mischung (b = 0,002; f = 2,5) wie beschrieben zunächst bei 500°C kalziniert und dann bei 690°C, 730°C und 770°C getempert.

Für die erfindungsgemäßen Mischoxide konnte eine deutliche Abhängigkeit von Reflexhalbwertsbreite und Lithium-Überstöchiometrie festgestellt werden. Mit zunehmender Lithium-Überstöchiometrie wurden die Reflexe schmaler.

Anschließend wurde die BET-Oberfläche mit der Lithiumüberstöchiometrie korreliert:
Durch Einfluss des Borats wurden Streuungen der Reflexhalbwertsbreite in Abhängigkeit von der Lithium-Überstöchiometrie, die bei Proben aus verschiedenen Synthesen auftraten "nivelliert" (s. Figur 2). Gleiches wurde bei der Messung der BET-Oberfläche der Proben beobachtet. Auch hier war in Gegenwart von Borat eine Nivellierung festzustellen (Figur 8).

Die BET-Werte für die Proben aus der Variation der Lithium-Überstöchiometrie sind in Tabelle 2 zusammengefasst.

**Tabelle 2:** BET-Oberfläche: Variation Li-Überstöchiometrie

| Probe | BET $m^2/g$ | T °C | Li (mol% auf Mn) |
|---|---|---|---|
| G1051B1 | 0,62 | 770 | 1,0 |
| G1051B1 | 1,07 | 730 | 1,0 |
| G1051B1 | 2,5 | 690 | 1,0 |
| G1031B2 | 0,6 | 770 | 1,5 |
| G1031B2 | 2,2 | 690 | 1,5 |
| G1052 | 4,91 | 770 | 2,0 |
| G1052B1 | 0,31 | 770 | 2,0 |
| G1052B1 | 0,92 | 730 | 2,0 |
| G1052B1 | 1,66 | 690 | 2,0 |
| G1053 | 4,85 | 770 | 2,5 |
| G1053B1 | 0,4 | 770 | 2,5 |
| G1053B1 | 1,04 | 730 | 2,5 |
| G1053B1 | 1,7 | 690 | 2,5 |

Insgesamt wirkt sich neben dem Boratzusatz und der Temperatur auch die Lithium-Überstöchiometrie auf die BET Oberfläche aus. Es wurden BET Werte < 1 $m^2/g$ gefunden.

Beispiel 6

*Cerimetrie*

Die Tatsache, dass überstöchiometrisches Lithium in das Spinellgitter eingebaut wird, wurde mittels Cerimetrie anhand eines erfindungsgemäßen Mischoxids mit Aluminium-dotiertem Manganspinell nachgewiesen. Der Einbau in das Spinellgitter verändert den mittleren Oxidationsgrad der Manganionen. Falls das Lithium nur als Flussmittel (in Form von $Li_2O$) vorliegen würde, betrüge der mittlerer Manganionenoxidationsgrad +3,56, bei einem strukturellen Einbau +3,62.

Die beiden strukturellen Grenzfälle lassen sich wie folgt darstellen:

Reines Flussmittel

$$Li_1[Li^{+1}_{0,029}Al^{+3}_{0,098}Mn^{+x}_{1,874}]O_4 \quad 0.071\ Li_2O*wB_2O_3$$

(fortgesetzt)

$$Mn^{+3.56}$$

Struktureller Lithiumeinbau

$$Li_1[Li^{+1}_{0,067}Al^{+3}_{0,094}Mn^{+x}_{1,839}]O_4 \quad w\ B_2O_3$$
$$Mn^{+3.62}$$

Die erhaltenen Werte, die in Tabelle 3 aufgeführt sind lagen im Bereich von +3,59 bis +3,69, was den strukturellen Einbau belegt.

**Tabelle 3** Mittels Cerimetrie bestimmter mittlerer Oxidationsgrad der Manganionen im Mischoxid Li[Li Al Mn]O$_4\cdot$B$_2$O$_3$.

| Probe | | | Temp | | Stöchiometrie | | | $M^{X+}$ | |
|---|---|---|---|---|---|---|---|---|---|
| | | | °C | Li | Li | Al | Mn | cerimetrisch | STDAW +/- |
| G1031 | B2 | | 500 | 1 | 0,081 | 0,095 | 1,824 | 3,69 | 0,04 |
| G1031 | B2 | T1 | 700 | 1 | 0,067 | 0,094 | 1,839 | 3,59 | 0,01 |
| G1031 | B2 | T2 | 730 | 1 | 0,070 | 0,095 | 1,835 | 3,63 | 0,01 |
| G1031 | B2 | T3 | 690 | 1 | 0,071 | 0,094 | 1,835 | 3,59 | 0,01 |
| G1051 | B1 | T2 | 730 | 1 | 0,076 | 0,092 | 1,832 | 3,60 | 0,01 |
| G1053 | | T1 | 770 | 1 | 0,055 | 0,094 | 1,851 | 3,63 | 0,01 |
| G1053 | B1 | T1 | 770 | 1 | 0,100 | 0,093 | 1,807 | 3,62 | 0,02 |
| G1053 | | T2 | 730 | 1 | 0,053 | 0,093 | 1,854 | 3,59 | 0,00 |
| G1053 | B1 | T2 | 730 | 1 | 0,097 | 0,092 | 1,811 | 3,60 | 0,01 |

Der erreichte Oxidationsgrad ist dabei abhängig von der Synthesetemperatur. Bei höheren Temperaturen lag der Oxidationsgrad etwas niedriger. Dieser Befund korreliert gut mit der vorstehend beschriebenen strukturellen temperaturabhängigen Verschiebung der Reflexlagen im XRD Spektrum.

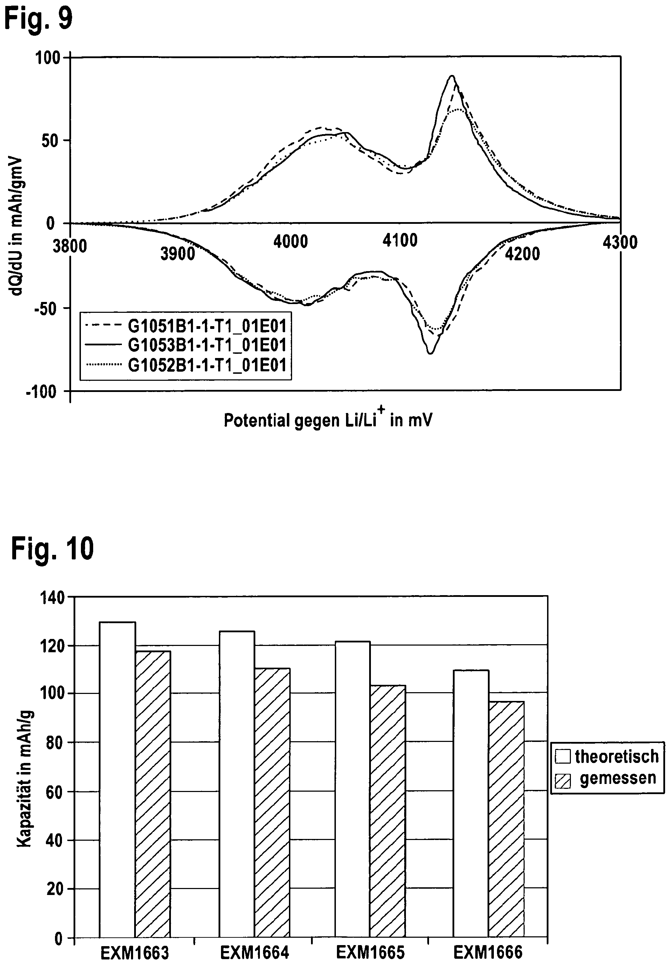

In Figur 9 sind dQ/dE vs E von Materialien verschiedener erfindungsgemäßer Mischoxide mit unterschiedlichen Lithium-Überstöchiometrien aufgetragen.

Beispiel 7

*Elektrochemische Untersuchung*

Figur 10 stellt die Entladekapazitäten von Proben erfindungsgemäßer Mischoxide im ersten Zyklus gegenüber. Der theoretische Wert wurde aus der analytisch ermittelten Spinellstöchiometrie errechnet. Die gemessenen Werte liegen zwischen 117 mAh/g für eine rein lithiumdotierte (überstöchiometrische) Probe (EXM 1666) und 96 mAh/g für eine Li/Al/Zn dotierte.

Die theoretische Maximalkapazität nimmt von 129 mAh/g für EXM 1663 auf 109 mAh/g für EXM1666 ab. Die Messwerte zeigen die gleiche Tendenz auf niedrigerem Niveau.

Die Musterproben zeigten vergleichsweise niedrige Kapazitäten, was auf den erhöhten Lithiumeinbau zurückgeführt werden kann.

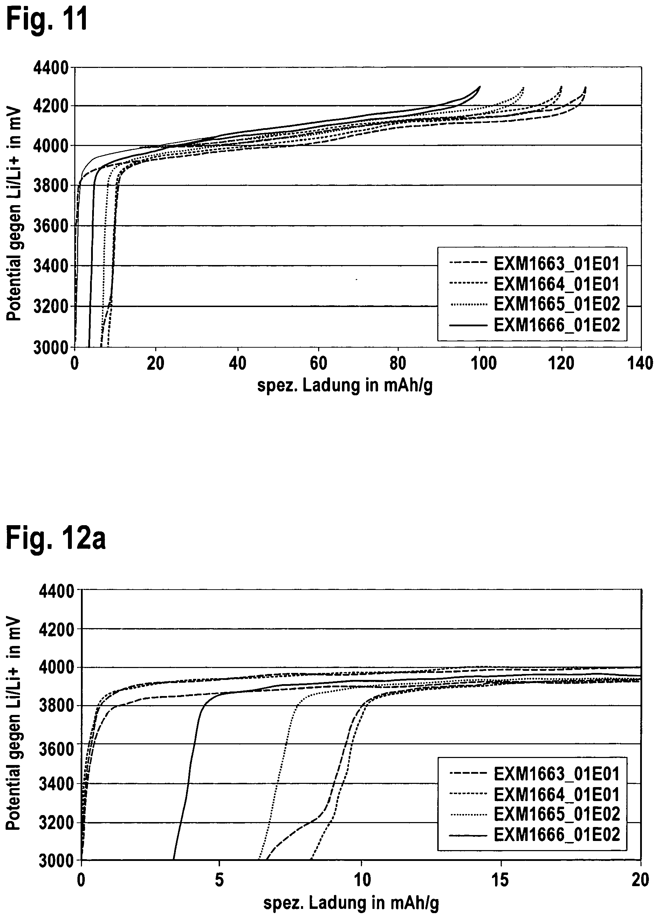

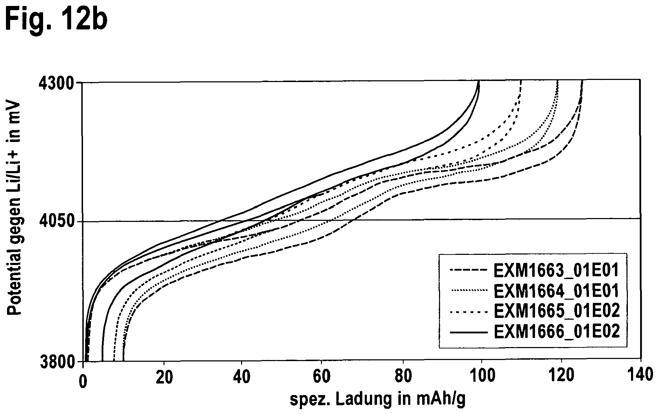

Figur 11 zeigt in der Übersicht die Potentialverläufe der Musterproben im ersten Vollzyklus. In Figur 12 ist das Augenmerk auf Potentialbereiche gelegt, die erste Hinweise auf das Zyklenverhalten der Proben gaben. Sowohl das Auftreten einer zusätzlichen Potentialstufe bei 3.2 Vals auch eine gut ausgeprägte Stufe bei halber Ladung/Entladung gelten als Merkmal schlechter Zyklenstabilität:

- Das Potentialplateau bei 3,2 V (Figur 12a, links) ist für die Al-freie Probe deutlich ausgeprägt, für die 3% Al dotierte Probe noch schwach zu erkennen und bei den mit 5% Al dotierten Mustern nicht mehr vorhanden.

- Die Ausprägung der Potentialstufe auf halber Ladung/Entladung nimmt in der Reihenfolge von EXM1663 nach EXM1666 ab.

<u>Beispiel 8</u>

*Technische Herstellung eines erfindungsgemäßen Lithium-Mangan-Spinell enthaltenden Mischoxides der Zusammensetzungsformel $(Li_{0,9,9}Zn_{0,01})[Mn_{1,87}Al_{0,1}Li_{0,03}]O_4 \cdot (0,9\ B_2O_3,\ 2*0,9\ Li_2O)$*

In mehreren Rühransätzen wurden jeweils folgende Rohstoffmengen eingesetzt:

| | | |
|---|---|---|
| $MnCO_3$ | 4,360 kg | 93,50% |
| $Mn(NO_3)_2$-Lsg. | 2,843 kg | 50% |
| $Al(NO_3)_3 * 9\ H_2O$ | 0,867 kg | 101% |
| $Zn(NO_3)_2 * 6\ H_2O$ | 70,2 g | 99% |
| $H_2O$ (dest.) | 3,530 kg | |
| $LiOH * H_2O$ | 1,063 kg | 55% |
| Borsäure | 12,80 g | 100,3% |

Das Wasser, die Mangannitrat-Lösung, das Aluminiumnitrat-Nonahydrat und das Zinknitrat-Hexahydrat wurden jeweils in einem 12l Kunststoffeimer vorgelegt und mit einem Pendraulik-Rührer mit Rührscheibe vermischt und vollständig zur Lösung gebracht. Dann wurden die fein-pulverförmige Borsäure und das auf einen D95-Wert von 27 μm vorgemahlene Mangancarbonat zugegeben. Der Pendraulik-Rührer wurde vorerst auf Stufe 3 gestellt, um die noch dünnflüssige Suspension homogen zu halten. Daraufhin wurde innerhalb von 1 min das pulverförmige Lithiumhydroxid zugegeben und auf Stufe 4 weiter 15 - 20 min gerührt. Die Viskosität der Suspension steigt dabei rasch an.

Die Rühransätze wurden in einem gerührten Vorlagebehälter vereinigt und die noch pumpfähige Suspension wurde in einem Sprühtrockner der Marke Storck Bowen mit Zweistoffdüse und Verdüsung von oben im Gleichstromverfahren bei einer Luft-Eintrittstemperatur von 550°C und einer Luftaustrittstemperatur zwischen 140°C und 145°C getrocknet. Es wurde ein braunes Pulver mit einem Schüttgewicht von 1011 g/l erhalten.

Das so erhaltene Trocknungsprodukt enthält noch Nitrate und wurde auf Edelstahl-Hordenblechen in einem Band-Durchlaufofen mit angeschlossener Abgasreinigungsanlage für Nitrose Gase bei 450°C und einer mittleren Verweildauer von 1 h in der Heizzone kalziniert. Dabei wurden überraschend niedrige Mengen an Nitrosen Gasen entwickelt und es wurde ein feines schwarzes Pulver mit einem Schüttgewicht von 823 g/l erhalten. Das Kalzinationsprodukt wurde anschließend in einem Alsint-Keramiktiegel im Kammerofen an Luft bei 770°C für 12 h getempert bei einer Aufheizzeit von 6 h und einer Abkühlzeit von 12 h.

Das bläulich schwarze Temperprodukt wurde auf einer AFG100 Sichter-Luftstrahlmühle von Alpine mit keramischem Sichterrad und keramischen Mahlluftdüsen von 3,0 mm Durchmesser bei einer Sichterdrehzahl von 5500 UPM vermahlen.

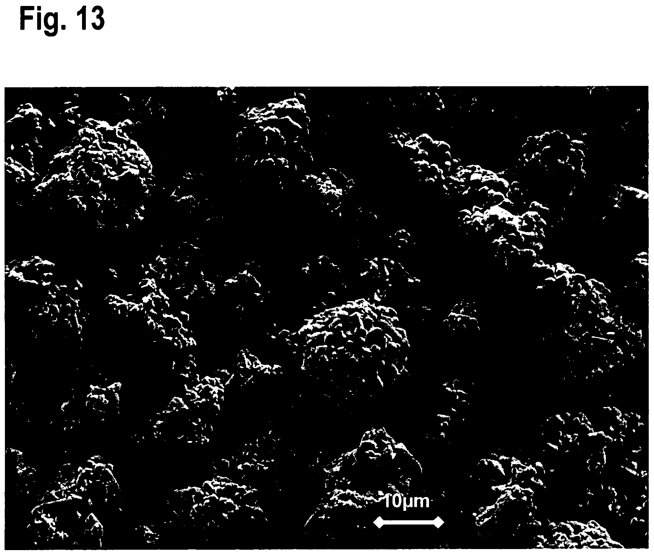

Das im Abscheidezyklon gesammelte Mahlprodukt hatte ein Schüttgewicht von 1045 g/l und ein Rüttelgewicht von 1713 g/l. Figur 13 stellt eine rasterelektronenmikroskopische Aufnahme des Produkts dar. Die mittels ICP bestimmte chemische Zusammensetzung war:

| | |
|---|---|
| Li | 3,9 % |
| Mn | 59,7 % |
| Al | 1,6 % |
| Zn | 3800 mg/kg |
| B | 600 mg/kg |
| S | 0,23 % |
| Na | 920 mg/kg |

Die Partikelgrößenverteilung war monomodal und durch folgende Parameter gekennzeichnet:

$D_{10} = 2,5\,\mu m$

$D_{50} = 10,8\,\mu m$

$D_{90} = 20,7\,\mu m$

$D_{100} = 35,6\,\mu m$

Weitere Produkteigenschaften waren:

| | | |
|---|---|---|
| pH-Wert: | 9,5 | |
| Restfeuchte: | 0.26 Gew.-% | (Karl-Fischer Methode) |
| Oberfläche nach BET: | <1 m$^2$/g | |
| Mikroporenvolumen: | <0.001 cm$^3$/g | (ASAP 2010, Micromeritics) |
| kubische Gitterkonstante a = 8,210 Å (nach Röntgenbeugung) | | |

Im elektrochemischen Zyklentest zeigt das erfindungsgemäße Lithium-Mangan-Spinell enthaltende Mischoxid eine Entladekapazität von 105 mAh/g und einen Zyklenverlust von weniger als 0,1 % pro Zyklus gemessen in einer Halbzelle des Typs LMS // LiPF6-EC-DMC // Li.

**Patentansprüche**

1. Mischoxid, enthaltend

   a) einen gemischt substituierten Lithium-Mangan-Spinell, bei dem ein Teil der Mangan-Gitterplätze durch Lithium-Ionen besetzt ist, und
   b) eine Bor-Sauerstoff-Verbindung, ausgewählt aus einem Boroxid, einer Borsäure oder deren Salzen,

   **dadurch gekennzeichnet, dass**
   das Mischoxid ein homophasiger homöotyper Mischkristall ist, der die Bestandteile a) und b) umfasst, wobei der Bestandteil b) in der gleichen Phase wie der Bestandteil a) vorliegt.

2. Mischoxid nach Anspruch 1, wobei im dotierten Lithium-Mangan-Spinell weitere Mangan-Gitterplätze durch ein Metallion N, ausgewählt aus der Gruppe bestehend aus Al, Mg, Zn, Co, Ni, Cu und Cr, besetzt sind.

3. Mischoxid nach Anspruch 2, wobei ein Teil der Lithium-ionen auf den 8a-Tetraederplätzen durch ein Metallion aus der Gruppe, bestehend aus Zn, Mg und Cu, ausgetauscht ist.

4. Mischoxid nach einem der Ansprüche 1 bis 3 mit der Formel:

   $$[(Li_{1-a}M_a)(Mn_{2-c-d}Li_cN_d)O_x] \cdot b(B_zO_yH_uX_v)$$

   wobei gilt:

   $0 \leq a < 0,1$;
   $d < 1,2$
   $3,5 < x < 4,5$;
   $0,01 < c < 0,06$
   $z = 1, 2$ oder $4$
   $y = 1, 2, 3$ oder $7$
   $u = 0, 1, 2$ oder $3$
   $v = 0, 1, 2$ oder $3$
   $0,01 < b < 0,5$

   - M zumindest ein Element aus der Gruppe von Zn, Mg und Cu ist;
   - N zumindest ein Element aus der Gruppe von Al, Mg, Co, Ni, Cu und Cr ist; und
   - X zumindest ein Element aus der Gruppe Li, Na und K ist.

5. Mischoxid nach einem der Ansprüche 1 bis 3 mit der Formel:

   $$[(Li_{1-a}M_a)(Mn_{2-c-d}Li_cN_d)O_x] \cdot (b\ B_2O_3 \cdot f^*b\ Li_2O)$$

   wobei gilt:

$0 \le a < 0,1$;
$d < 1,2$
$3,5 < x < 4,5$;
$0,01 < c < 0,06$
$0 < b < 0,05$
$1 < f < 4$;

- M zumindest ein Element aus der Gruppe von Zn, Mg und Cu ist;
- N zumindest ein Element aus der Gruppe von Al, Mg, Co, Ni, Cu und Cr ist.

6. Mischoxid nach Anspruch 4 oder 5 mit einer BET-Oberfläche von weniger als 4 m$^2$/g.

7. Mischoxid nach Anspruch 6, wobei die Größe der Primärkristallite des Mischoxids mindestens 0,5 $\mu$m, vorzugsweise größer als 1 $\mu$m beträgt.

8. Elektrode, umfassend einen elektrisch leitfähigen Träger, auf welchem ein Mischoxid nach einem der Ansprüche 1 bis 7 aufgetragen ist.

9. Sekundärbatterie mit einer Elektrode nach Anspruch 8.

10. Verfahren zur Herstellung eines Mischoxids enthaltend einen gemischt dotierten überstöchiometrischen Lithium-Mangan-Spinell nach einem der Ansprüche 1 bis 7, wobei

(a) zumindest eine Lithiumkomponente, eine Mangankomponente, eine Borkomponente, eine Komponente enthaltend N, wobei N ausgewählt ist aus der Gruppe von Al, Mg, Co, Ni, Cu und Cr, und/oder eine Komponente enthaltend M, wobei M ausgewählt ist aus Zn, Mg und Cu, bereitgestellt wird;
(b) ein erster Anteil einer festen Mischung hergestellt wird, indem ein Teil der Komponenten aus (a) in trockener, pulverförmiger Form vermischt wird;
(c) ein zweiter Anteil einer flüssigen Mischung hergestellt wird, welcher einen Anteil der Komponenten aus (a) in gelöster Form und/oder als Suspension enthält;
(d) der erste Anteil (b) und der zweite Anteil (c) vermischt werden;
(e) der in (d) erhaltenen Mischung das Lösungsmittel entzogen wird;
(f) die in (e) erhaltene Mischung bei einer Temperatur von mehr als 300°C kalziniert wird,

wobei die stöchiometrischen Mengen der Komponenten des ersten Anteils (b) und des zweiten Anteils (c) so ausgewählt sind, dass sich ein Mischoxid der folgenden Formel ergibt:

$$[(Li_{1-a}M_a) (Mn_{2-c-d}Li_cN_d) O_x] \cdot b (B_zO_yH_uX_v)$$

wobei gilt:

$0 \le a < 0,1$;
$d < 1,2$
$3,5 < x < 4,5$;
$0,01 < c < 0,06$
$z = 1, 2$ oder 4
$y = 1, 2, 3$ oder 7
$u = 0, 1, 2$ oder 3
$v = 0, 1, 2$ oder 3
$0,01 < b < 0,5$

- M zumindest ein Element aus der Gruppe von Zn, Mg und Cu ist;
- N zumindest ein Element aus der Gruppe von Al, Mg, Co, Ni, Cu und Cr ist; und
- X zumindest ein Element aus der Gruppe Li, Na und K ist,

wobei zusätzliches Li in einem Molverhältnis f = Li/B von 1 bis 4 zu 1 zugegeben wird.

11. Verfahren nach Anspruch 10, wobei die Kalzinierung in wenigstens zwei Schritten durchgeführt wird, wobei in einem ersten Schritt bei Temperaturen von 300 bis 600°C und in einem zweiten Schritt bei Temperaturen von 600 bis 900°C kalziniert wird.

12. Verfahren nach Anspruch 10 oder 11, wobei der durch Lasergranulometrie bestimmte $D_{50}$-Wert der ersten Komponente kleiner als 30 $\mu$m gewählt wird.

13. Verfahren nach Anspruch 12, wobei die Mangankomponente vor dem Vermischen so fein vermahlen wird, dass ein durch Lasergranulometrie bestimmter $D_{95}$-Wert von weniger als 30 $\mu$m eingestellt wird.

14. Verfahren nach Anspruch 13, wobei der zweite Anteil (c) einen Anteil der Mangankomponente und/oder der Komponente N enthält.

15. Verfahren nach Anspruch 14, wobei der erste Anteil (b) in den zweiten Anteil (c) eingerührt wird.

16. Verfahren nach Anspruch 10, in dem N ausgewählt wird aus Al und Mg, und M ausgewählt wird aus Zn.


**Claims**

1. Mixed oxide, containing:

   a) a mixed substituted lithium-manganese spinel, in which some of the manganese lattice sites are occupied by lithium ions, and
   b) a boron-oxygen compound, selected from a boron oxide, a boric acid or salts thereof,

   **characterised in that**
   the mixed oxide is a homophasic homotype mixed crystal that comprises the constituents a) and b), constituent b) being present in the same phase as constituent a).

2. Mixed oxide according to claim 1, wherein, in the doped lithium-manganese spinel, further manganese lattice sites are occupied by a metal ion N, selected from the group consisting of Al, Mg, Zn, Co, Ni, Cu and Cr.

3. Mixed oxide according to claim 2, wherein some of the lithium ions on the 8a tetrahedral sites are replaced by a metal ion from the group consisting of Zn, Mg and Cu.

4. Mixed oxide according to any of claims 1 to 3, having the formula:

$$[(Li_{1-a}M_a)(Mn_{2-c-d}Li_cN_d)O_x] \cdot b(B_zOyH_uX_v)$$

   wherein:

   $0 \leq a < 0.1$;
   $d < 1.2$
   $3.5 < x < 4.5$;
   $0.01 < c < 0.06$
   $z = 1, 2$ or $4$
   $y = 1, 2, 3$ or $7$
   $u = 0, 1, 2$ or $3$
   $v = 0, 1, 2$ or $3$
   $0.01 < b < 0.5$

   - M is at least one element from the group of Zn, Mg and Cu;
   - N is at least one element from the group of Al, Mg, Co, Ni, Cu and Cr; and
   - X is at least one element from the group Li, Na and K.

5. Mixed oxide according to any of claims 1 to 3, having the formula:

$$[(Li_{1-a}M_a)(Mn_{2-c-d}Li_cN_d)O_x] \cdot (b \, B_2O_3 \bullet f^*b \, Li_2O)$$

wherein:

$0 \leq a < 0.1$;
$d < 1.2$
$3.5 < x < 4.5$;
$0.01 < c < 0.06$
$0 < b < 0.05$
$1 < f < 4$;

    - M is at least one element from the group of Zn, Mg and Cu;
    - N is at least one element from the group of Al, Mg, Co, Ni, Cu and Cr.

6. Mixed oxide according to either claim 4 or claim 5, having a BET surface area of less than 4 $m^2$/g.

7. Mixed oxide according to claim 6, wherein the size of the primary crystallite of the mixed oxide is at least 0.5 $\mu$m, preferably greater than 1 $\mu$m.

8. Electrode comprising an electrically conductive substrate, on which a mixed oxide according to any of claims 1 to 7 is applied.

9. Secondary battery comprising an electrode according to claim 8.

10. Method for producing a mixed oxide containing a mixed-doped superstoichiometric lithium-manganese spinel according to any of claims 1 to 7, wherein

(a) at least one lithium component, a manganese component, a boron component, a component containing N, N being selected from the group of Al, Mg, Co, Ni, Cu and Cr, and/or a component containing M, M being selected from Zn, Mg and Cu, is prepared;
(b) a first proportion of a solid mixture is produced by some of the components from (a) being mixed in a dry, powdered form;
(c) a second proportion of a liquid mixture is produced, which contains a proportion of the components from (a) in soluble form and/or as a suspension;
(d) the first proportion (b) and the second proportion (c) are mixed;
(e) the solvent is separated from the mixture obtained in (d);
(f) the mixture obtained in (e) is calcinated at a temperature greater than 300°C,

wherein the stoichiometric quantities of the components of the first proportion (b) and the second proportion (c) are selected such that a mixed oxide of the following formula results:

$$[(Li_{1-a}M_a)(Mn_{2-c-d}Li_cN_d)O_x] \cdot b\ (B_zOyH_uX_v)$$

wherein:

$0 \leq a < 0.1$;
$d < 1.2$
$3.5 < x < 4.5$;
$0.01 < c < 0.06$
$z = 1, 2$ or $4$
$y = 1, 2, 3$ or $7$
$u = 0, 1, 2$ or $3$
$v = 0, 1, 2$ or $3$
$0.01 < b < 0.5$

    - M is at least one element from the group of Zn, Mg and Cu;
    - N is at least one element from the group of Al, Mg, Co, Ni, Cu and Cr; and
    - X is at least one element from the group Li, Na and K,

wherein Li in a molar ratio f = Li/B of 1-4:1 is additionally added.

**11.** Method according to claim 10, wherein the calcination is carried out in at least two steps, in which, in a first step, is calcinated at temperatures of from 300 to 600°C and, in a second step, is calcinated at temperatures of from 600 to 900°C.

**12.** Method according to either claim 10 or claim 11, wherein the $D_{50}$ value of the first component, which value is determined by laser granulometry, is selected to be smaller than 30 $\mu$m.

**13.** Method according to claim 12, wherein, prior to mixing, the manganese components are so finely milled that a $D_{95}$ value, determined by laser granulometry, of less than 30 $\mu$m is set.

**14.** Method according to claim 13, wherein the second proportion (c) contains a proportion of the manganese component and/or the component N.

**15.** Method according to claim 14, wherein the first proportion (b) is stirred into the second proportion (c).

**16.** Method according to claim 10, in which N is selected from Al and Mg, and M is selected from Zn.

**Revendications**

**1.** Oxyde mixte, contenant

a) un spinelle de lithium et de manganèse substitué de façon mixte, dans lequel une partie des positions réticulaires du manganèse sont occupées par des ions lithium, et
b) un composé de bore et d'oxygène, sélectionné parmi un oxyde de bore, un acide borique ou des sels de ceux-ci,

**caractérisé en ce que**
l'oxyde mixte est un cristal mixte homologue homophasique qui comporte les constituants a) et b), dans lequel le constituant b) est présent dans la même phase que le constituant a).

**2.** Oxyde mixte selon la revendication 1, dans lequel d'autres positions réticulaires du manganèse dans le spinelle de lithium et de manganèse dopé sont occupées par un ion métallique N, sélectionné dans le groupe constitué d'Al, de Mg, de Zn, de Co, de Ni, de Cu et de Cr.

**3.** Oxyde mixte selon la revendication 2, dans lequel une partie des ions lithium sur les positions tétraédriques 8a sont remplacés par un ion métallique issu du groupe constitué de Zn, de Mg et de Cu.

**4.** Oxyde mixte selon l'une des revendications 1 à 3 ayant la formule :

$$[(Li_{1-a}M_a)(Mn_{2-c-d}Li_cN_d)O_x] \cdot b(B_zO_yH_uX_v)$$

dans laquelle :

$0 \leq a < 0,1$ ;
$d < 1,2$
$3,5 < x < 4,5$ ;
$0,01 < c < 0,06$
$z = 1, 2$ ou $4$
$y = 1, 2, 3$ ou $7$
$u = 0, 1, 2$ ou $3$
$v = 0, 1, 2$ ou $3$
$0,01 < b < 0,5$

- M est au moins un élément issu du groupe de Zn, de Mg et de Cu ;
- N est au moins un élément issu du groupe d'Al, de Mg, de Co, de Ni, de Cu et de Cr ; et
- X est au moins un élément issu du groupe de Li, de Na et de K.

**5.** Oxyde mixte selon l'une des revendications 1 à 3 ayant la formule :

$$[(Li_{1-a}M_a)(Mn_{2-c-d}Li_cN_d)O_x] \bullet (bB_2O_3 \bullet f * b\ Li_2O)$$

dans laquelle :

$0 \leq a < 0,1$ ;
$d < 1,2$
$3,5 < x < 4,5$ ;
$0,01 < c < 0,06$
$0 < b < 0,05$
$1 < f < 4$ ;

- M est au moins un élément issu du groupe de Zn, de Mg et de Cu ;
- N est au moins un élément issu du groupe d'Al, de Mg, de Co, de Ni, de Cu et de Cr.

**6.** Oxyde mixte selon la revendication 4 ou la revendication 5 avec une surface BET de moins de 4 $m^2$/g.

**7.** Oxyde mixte selon la revendication 6, dans lequel la dimension des cristallites primaires de l'oxyde mixte s'élève à au moins 0,5 $\mu$m, de préférence à plus de 1 $\mu$m.

**8.** Électrode, comportant un support électriquement conducteur sur lequel est déposé un oxyde mixte selon l'une des revendications 1 à 7.

**9.** Batterie secondaire avec une électrode selon la revendication 8.

**10.** Procédé de production d'un oxyde mixte contenant un spinelle de lithium et de manganèse surstoechiométrique dopé de façon mixte selon l'une des revendications 1 à 7, dans lequel

(a) il est préparé au moins un composant de lithium, un composant de manganèse, un composant de bore, un composant contenant N, dans lequel N est sélectionné dans le groupe d'Al, de Mg, de Co, de Ni, de Cu et de Cr, et/ou un composant contenant M, dans lequel M est sélectionné parmi Zn, Mg et Cu ;
(b) il est produit une première fraction d'un mélange solide par mélange d'une partie des composants de (a) sous forme pulvérulente sèche ;
(c) il est produit une deuxième fraction d'un mélange liquide, laquelle contient une fraction des composants de (a) sous forme dissoute et/ou sous forme de suspension ;
(d) la première fraction (b) et la deuxième fraction (c) sont mélangées ;
(e) le solvant est retiré du mélange obtenu en (d) ;
(f) le mélange obtenu en (e) est calciné à une température de plus de 300 °C,

dans lequel les quantités stoechiométriques des composants de la première fraction (b) et de la deuxième fraction (c) sont sélectionnées de telle sorte qu'un oxyde mixte de la formule suivante soit obtenu :

$$[(Li_{1-a}M_a)(Mn_{2-c-d}Li_cN_d)O_x] \bullet b(B_zOyH_uX_v)$$

dans laquelle :

$0 \leq a < 0,1$ ;
$d < 1,2$
$3,5 < x < 4,5$ ;
$0,01 < c < 0,06$
$z = 1, 2$ ou $4$
$y = 1, 2, 3$ ou $7$
$u = 0, 1, 2$ ou $3$
$v = 0, 1, 2$ ou $3$
$0,01 < b < 0,5$

- M est au moins un élément issu du groupe de Zn, de Mg et de Cu ;

- N est au moins un élément issu du groupe d'Al, de Mg, de Co, de Ni, de Cu et de Cr ; et
- X est au moins un élément issu du groupe de Li, de Na et de K, dans lequel du Li supplémentaire est ajouté dans un rapport molaire f = Li/B de 1 à 4 pour 1.

11. Procédé selon la revendication 10, dans lequel la calcination est effectuée en au moins deux étapes, dans lequel il est calciné dans une première étape à des températures de 300 à 600 °C et dans une deuxième étape à des températures de 600 à 900 °C.

12. Procédé selon la revendication 10 ou la revendication 11, dans lequel la valeur $D_{50}$ du premier composant déterminée par granulométrie laser est choisie inférieure à 30 $\mu$m.

13. Procédé selon la revendication 12, dans lequel le composant de manganèse est broyé avant le mélange de manière suffisamment fine pour qu'une valeur $D_{95}$ déterminée par granulométrie laser soit ajustée à moins de 30 $\mu$m.

14. Procédé selon la revendication 13, dans lequel la deuxième fraction (c) contient une fraction du composant de manganèse et/ou du composant N.

15. Procédé selon la revendication 14, dans lequel la première fraction (b) est délayée dans la deuxième fraction (c).

16. Procédé selon la revendication 10, dans lequel N est sélectionné parmi Al et Mg, et M est sélectionné parmi Zn.

# Fig. 1

# Fig. 2

## Fig. 3

```
          ┌─────────┐
          │ Fällung │
          └─────────┘
               │
      ┌──────────────────┐
      │  Vortrocknung    │
      └──────────────────┘
               │      ┌──────────────┐
               │──────│ Li/B-Addition│
               │      └──────────────┘
      ┌──────────────────┐
      │   Zwischen-      │
      │   trocknung      │
      └──────────────────┘
               │
      ┌──────────────────┐
      │  Vortemperung    │
      │     500°C        │
      └──────────────────┘
               │
      ┌──────────────────┐
      │  Endtemperung    │
      └──────────────────┘
        │         │         │
   ┌────────┐ ┌────────┐ ┌────────┐
   │ 690°C  │ │ 730°C  │ │ 770°C  │
   └────────┘ └────────┘ └────────┘
```

## Fig. 4

1.0 %

Gew.-%
Borat

0.5 %

0.0 %

690°C          730°C          770°C

# Fig. 5

# Fig. 6

# Fig. 7

Manganauflösung in mg Mn/kg

y = 206,44x +
155,16
$R^2 = 1$

○ Mittelwerte
× Einzelwerte 0% Borat
× Einzelwerte 0.5% Borat
× Einzelwerte 1% Borat
— Linear (Mittelwerte)

BET - Oberfläche in m $^2$/g

# Fig. 8

BET in m$^2$/g

Li - dotation

○ 770
◇ 730
□ 690
○ 770°C  1031
□ 690°C  1031

## Fig. 9

## Fig. 10

## Fig. 11

## Fig. 12a

# Fig. 12b

## Fig. 13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4507371 A
- US 5316877 A
- EP 0783459 B1
- EP 1035075 A1
- EP 1204601 B1
- EP 0993058 A1
- JP 2001048545 A
- EP 1136446 A2
- DE 19913925 A1
- US 7217406 B
- JP 2001048547 A
- US 20030054248 A1

**In der Beschreibung aufgeführte Nicht-Patentliteratur**

- **ROBERTSON et al.** *J. Electrochem. Soc.,* 1997, vol. 144 (10), 3500-3512
- **P. STROBEL et al.** Cation Ordering in Substituted LiMn2O4 Spinels. *Mat. Res. Soc. Symp. Vol. Proc.,* 756
- **HOLLEMANN-WIBERG.** Lehrbuch der Anorganischen Chemie. de Gruyter, 2007, 130-131
- **HOLLEMANN-WIBERG.** Lehrbuch der Anorganischen Chemie. de Gruyter, 2007, 1104-1110
- **U. R. KUNZE.** Grundlagen der quantitativen Analyse. Thieme Verlag, 1986, 207